# EUROPEAN PATENT APPLICATION

(11) **EP 4 586 285 A1**
(43) Date of publication of application: **16.07.2025**
(21) Application number: 25150746.3
(22) Date of filing: 08.01.2025
(51) Int. Cl.: H01F 1/26, H01F 1/37

(54) **RESIN COMPOSITION**

(30) Priority: 12.01.2024 JP 2024003205; 20.11.2024 JP 2024202530
(71) Applicant: AJINOMOTO CO., INC., Chuo-ku Tokyo 104-8315 (JP)
(72) Inventor: TANAKA, Takayuki, Kanagawa, 210-0801 (JP)
(74) Representative: Mewburn Ellis LLP

(57) **Abstract**

A resin composition comprising: (A) a Ni-containing iron alloy type magnetic powder; (B) a Mn-containing ferrite type magnetic powder; and (C) a thermosetting resin, the component (A) containing a Fe-Ni-Cr type alloy magnetic powder, the component (B) containing or not containing a Zn-containing ferrite type magnetic power, and a mass ratio ((Mn + Zn)/Fe) of a total amount of Mn and Zn to an amount of Fe in an entire magnetic powder contained in the component (A) and the component (B) being 0.055 or more and 0.16 or less.

## Description

### BACKGROUND OF THE INVENTION

### Technical Field

The present invention relates to a resin composition and a cured product, a magnetic paste, a resin sheet, a circuit board, and an inductor substrate containing the resin composition.

### Background Art

As a core material of an inductor component, a cured product obtained by curing a resin composition containing a magnetic powder may be used. As the magnetic powder, a FeNi alloy powder may be used (Patent Literature 1) .

### Citation List

### Patent Literature

Patent Literature 1: Japanese Patent Application Laid-open No. 2018-178254

### Summary of the Invention

### Technical Problem

Conventionally, independent inductor components have generally been mounted on a substrate for a semiconductor device. However, in recent years, a method for forming a coil as a conductor pattern of the substrate to form an inductor element inside the substrate has been used in a certain case. To further improve the performance of inductor elements used in such an application, there is a demand for further improving the magnetic characteristics of core materials. Specifically, there is a demand for developing a technology that can achieve a core material with high specific magnetic permeability and low magnetic loss by means of a cured product of a resin composition containing a magnetic powder.

The present invention has been made in view of the above problem, and an object thereof is to provide a resin composition that can produce a cured product with improved specific magnetic permeability and magnetic loss; a cured product of the resin composition; a magnetic sheet and a resin sheet containing the resin composition; and a circuit board and an inductor substrate including a cured product of the resin composition.

### Solution to Problem

The inventor of the present invention has intensively studied in order to solve the above problem. Consequently, the inventor of the present invention has found that a resin composition containing (A) a Ni-containing iron alloy type magnetic powder, (B) a Mn-containing ferrite type magnetic powder, and (C) a thermosetting resin in combination, the component (A) containing a Fe-Ni-Cr type alloy magnetic powder, the component (B) containing or not containing a Zn-containing ferrite type magnetic power, and the resin composition containing a mass ratio of a total amount of Mn and Zn to an amount of Fe in an entire magnetic powder contained in the component (A) and the component (B) satisfying a specific value range can solve the above problem to complete the present invention.

That is, the present invention includes the following.
<1> A resin composition comprising:
   (A) a Ni-containing iron alloy type magnetic powder;
   (B) a Mn-containing ferrite type magnetic powder; and
   (C) a thermosetting resin,

   the component (A) containing a Fe-Ni-Cr type alloy magnetic powder,
   the component (B) containing or not containing a Zn-containing ferrite type magnetic power, and
   a mass ratio ((Mn + Zn)/Fe) of a total amount of Mn and Zn to an amount of Fe in an entire magnetic powder contained in the component (A) and the component (B) being 0.055 or more and 0.16 or less.
<2> The resin composition according to <1>, wherein the component (B) has a smaller average particle size (D₅₀) than the component (A).
<3> The resin composition according to <1> or <2>, wherein the component (C) contains (C-1) an epoxy resin.
<4> The resin composition according to any one of <1> to <3>, wherein the component (C) contains (C-2) a curing agent.
<5> The resin composition according to any one of <1> to <4>, further comprising (E) a thermoplastic resin.
<6> The resin composition according to any one of <1> to <5>, further comprising (F) a curing accelerator.
<7> The resin composition according to any one of <1> to <6>, further comprising (G) a dispersant.
<8> The resin composition according to any one of <1> to <7>, wherein a content of Ni contained in the component (A) is 33% by mass or more and 65% by mass or less relative to 100% by mass of the component (A).
<9> The resin composition according to any one of <1> to <8>, wherein a content of Mn contained in the component (B) is 5% by mass or more and 35% by mass or less relative to 100% by mass of the component (B).
<10> The resin composition according to any one of <1> to <9>, wherein an amount of the component (A) is 30% by volume or more relative to 100% by volume of nonvolatile components in the resin composition.
<11> The resin composition according to any one of <1> to <10>, wherein an amount of the component (A) is 40% by mass or more relative to 100% by mass of nonvolatile components in the resin composition.
<12> The resin composition according to any one of <1> to <11>, wherein an amount of the component (B) is 10% by volume or more relative to 100% by volume of nonvolatile components in the resin composition.
<13> The resin composition according to any one of <1> to <12>, wherein an amount of the component (B) is 10% by mass or more relative to 100% by mass of nonvolatile components in the resin composition.
<14> The resin composition according to any one of <1> to <13>, wherein a total amount of the component (A) and the component (B) is 60% by volume or more relative to 100% by volume of nonvolatile components in the resin composition.
<15> The resin composition according to any one of <1> to <14>, wherein a total amount of the component (A) and the component (B) is 70% by mass or more relative to 100% by mass of nonvolatile components in the resin composition.
<16> The resin composition according to any one of <1> to <15>, wherein the resin composition is for hole filling.
<17> A cured product of the resin composition according to any one of <1> to <16>.
<18> A magnetic paste comprising the resin composition according to any one of <1> to <16>.
<19> A resin sheet comprising:
   a support; and
   a resin composition layer provided on the support,
   the resin composition layer containing the resin composition according to any one of <1> to <16>.
<20> A circuit board comprising:
   a substrate having holes; and
   a cured product of the resin composition according to any one of <1> to <16> filled in the holes.
<21> A circuit board comprising a cured product layer containing a cured product of the resin composition according to any one of <1> to <16>.
<22> An inductor substrate comprising the circuit board according to <21>.

### Advantageous Effects of Invention

The present invention can provide a resin composition that can produce a cured product with improved specific magnetic permeability and magnetic loss; a cured product of the resin composition; a magnetic paste and a resin sheet containing the resin composition; and a circuit board and an inductor substrate including a cured product of the resin composition.

### Brief Description of Drawings

FIG. 1 is a sectional view schematically illustrating the core substrate prepared in a method for producing the circuit board according to the first example of one embodiment of the present invention.
FIG. 2 is a sectional view schematically illustrating the core substrate formed with through holes in the method production method of the circuit board according to the first example of the embodiment of the present invention.
FIG. 3 is a schematic cross sectional view illustrating the core substrate formed with a plated layer in the through hole in the production method of the circuit board according to the first example of one embodiment of the present invention.
FIG. 4 is a schematic cross sectional view illustrating the state of the through hole in the core substrate filled with the resin composition in the production method of the circuit board according to the first example of one embodiment of the present invention.
FIG. 5 is a schematic cross sectional view to explain the step (2) in the production method of the circuit board according to the first example of one embodiment of the present invention.
FIG. 6 is a schematic cross sectional view to explain the step (3) in the production method of the circuit board according to the first example of one embodiment of the present invention.
FIG. 7 is a schematic cross sectional view to explain the step (5) in the production method of the circuit board according to the first example of one embodiment of the present invention.
FIG. 8 is a schematic cross sectional view to explain the step (5) in the production method of the circuit board according to the first example of one embodiment of the present invention.
FIG. 9 is a schematic cross sectional view to explain the step (i) in the production method of the circuit board according to the second example of one embodiment of the present invention.
FIG. 10 is a schematic cross sectional view to explain the step (i) in the production method of the circuit board according to the second example of one embodiment of the present invention.
FIG. 11 is a schematic cross sectional view to explain the step (ii) in the production method of the circuit board according to the second example of one embodiment of the present invention.
FIG. 12 is a schematic cross sectional view to explain the step (iv) in the production method of the circuit board according to the second example of one embodiment of the present invention.
FIG. 13 is a schematic plan view of the circuit board that possessed by the inductor substrate, observed from one side in the thickness direction thereof.
FIG. 14 is a schematic view illustrating the cut end face of a circuit board that is cut at the position indicated by the II-II single-dotted line in FIG. 13.
FIG. 15 is a schematic plan view to explain the composition of the first conductor layer of the circuit board included in the inductor substrate.

### Description of Embodiments

Hereinafter, the present invention will be described in detail by embodiments and examples. The present invention is not limited to the embodiments and examples described below, thus, the present invention may be carried out with any modification so far as such modification is not outside the claims or the equivalent thereof.

In the following description, "nonvolatile components" of a resin composition represent components except a solvent out of components contained in the resin composition. The "resin component" of a resin composition represents a component except inorganic particles such as magnetic powders out of the nonvolatile components contained in the resin composition.

In the following description, the "magnetic permeability" represents "specific magnetic permeability" unless otherwise specified.

### Resin Composition

The resin composition of the present invention is a resin composition containing (A) a Ni-containing iron alloy type magnetic powder, (B) a Mn-containing ferrite type magnetic powder, and (C) a thermosetting resin in which the component (A) contains a Fe-Ni-Cr type alloy magnetic powder, the component (B) contains or does not contain a Zn-containing ferrite type magnetic power, and the mass ratio ((Mn + Zn)/Fe) of a total amount of Mn and Zn to an amount of Fe in an entire magnetic powder contained in the component (A) and the component (B) is 0.055 or more and 0.16 or less. Such a resin composition can improve the specific magnetic permeability and the magnetic loss of a cured product of the resin composition. Specifically, the specific magnetic permeability of the cured product can be increased and the magnetic loss thereof can be decreased.

The resin composition of the present invention can produce a cured product with improved specific magnetic permeability and magnetic loss. The cured product of the resin composition of the present invention has a higher magnetic permeability and a lower magnetic loss than a cured product of a conventional resin composition that does not satisfy the relation in which the mass ratio ((Mn + Zn)/Fe) of the total amount of Mn and Zn to the amount of Fe in the entire magnetic powder contained in the component (A) and the component (B) is 0.055 or more and 0.16 or less.

Cured products of resin compositions containing Ni-containing iron alloy type magnetic powders (and hence Fe-Ni-Cr type alloy magnetic powders) have generally been able to have a high specific magnetic permeability but have had a tendency to have a high magnetic loss. Thus, it has conventionally been difficult to obtain a cured product having a high specific magnetic permeability and a low magnetic loss. In view of such conventional circumstances, the effect of the above resin composition that can improve both the specific magnetic permeability and the magnetic loss is industrially beneficial.

In the resin composition of the present invention, when the component (B) does not contain the "Zn-containing ferrite type magnetic powder," in the "mass ratio ((Mn + Zn)/Fe) of a total amount of Mn and Zn to an amount of Fe in an entire magnetic powder contained in the component (A) and the component (B)" described above, the content of Zn may be zero. Thus, about an aspect in which the component (B) does not contain the "Zn-containing ferrite type magnetic powder," the resin composition of the present invention has a mass ratio (Mn/Fe) of an amount of Mn to an amount of Fe in an entire magnetic powder contained in the component (A) and the component (B) of 0.055 or more and 0.16 or less.

The following describes the components contained in the resin composition in detail.

### (A) Ni-Containing Iron Alloy Type Magnetic Powder

The resin composition contains (A) the Ni-containing iron alloy type magnetic powder as the component (A). The component (A) also contains a Fe-Ni-Cr type alloy magnetic powder. As to (A) the Ni-containing iron alloy type magnetic powder, one may be used alone or two or more may be used in combination.

In addition to the Fe-Ni-Cr type alloy magnetic powder, the component (A) may further contain iron alloy type magnetic powders containing any elements other than Fe, Ni and, Cr. Thus, (A) the Ni-containing iron alloy type magnetic powder may contain, in addition to the Fe-Ni-Cr type alloy magnetic powder, iron alloy type magnetic powders such as a Fe-Ni-Si type alloy magnetic powder, a Fe-Ni-B type alloy magnetic powder, a Fe-Ni-Mo type alloy magnetic powder, a Fe-Ni-Si-Cr type alloy magnetic powder, and a Fe-Ni-Mo-Cu type alloy magnetic powder. Note that in the present specification, the term "E₁-E₂ type alloy magnetic powder" represents an alloy magnetic powder containing an element E₁ and an element E₂, and the term "E₁-E₂-E₃ type alloy magnetic powder" represents an alloy magnetic powder containing elements E₁, E₂, and E₃. The same applies to alloy magnetic powders containing four or more elements.

Examples of the optional elements that the component (A) may contain include elements derived from impurities that may inevitably be mixed therein in accordance with a method for producing the component (A). Specific examples of the elements derived from impurities that may inevitably be mixed therein include P, S, Mn, Mo, Cu, and Co. However, from the viewpoint of markedly exhibiting the effect of the present invention, the amount of the elements derived from impurities contained in the component (A) is preferably less than 1% by mass relative to 100% by mass of the component (A).

In a preferred embodiment, the component (A) contains one or more magnetic powders selected from the group consisting of a Fe-Ni-Cr type alloy magnetic powder and a Fe-Ni-Si-Cr type alloy magnetic powder.

The amount of each element contained in the component (A) can be measured with an inductively coupled plasma optical emission spectrometer (for example, "ICP-OES 720ES" manufactured by Agilent Technologies, Inc.).

The amount of Fe contained in the component (A) is preferably 33% by mass or more, more preferably 38% by mass or more, and even more preferably 43% by mass or more or 48% by mass or more, and is preferably 65% by mass or less, more preferably 60% by mass or less, and even more preferably 55% by mass or less or 53% by mass or less relative to 100% by mass of the component (A). When the amount of Fe is within the above range, the specific magnetic permeability and the magnetic loss of the cured product of the resin composition can effectively be made good.

The amount of Ni contained in the component (A) is preferably 33% by mass or more, more preferably 38% by mass or more, and even more preferably 42% by mass or more or 44% by mass or more, and is preferably 65% by mass or less, more preferably 60% by mass or less, and even more preferably 52% by mass or less or 48% by mass or less relative to 100% by mass of the component (A). When the amount of Ni is within the above range, the specific magnetic permeability and the magnetic loss of the cured product of the resin composition can effectively be made good.

The total amount of Fe and Ni contained in the component (A) is preferably 85% by mass or more, more preferably 87% by mass or more, and even more preferably 92% by mass or more, and is preferably 99% by mass or less, more preferably 98.5% by mass or less, and even more preferably 98% by mass or less relative to 100% by mass of the component (A). When the total content of Fe and Ni is within the above range, the specific magnetic permeability and the magnetic loss of the cured product of the resin composition can effectively be made good.

The mass ratio (Fe/Ni) between the amount of Fe and the amount of Ni contained in the component (A) is preferably 0.5 or more, more preferably 0.7 or more, and even more preferably 1 or more, and is preferably 1.21 or less, more preferably 1.19 or less, and even more preferably 1.17 or less. When the ratio (Fe/Ni) between the amount of Fe and the amount of Ni is within the above range, the specific magnetic permeability and the magnetic loss of the cured product of the resin composition can effectively be made good.

The amount of Cr contained in the component (A) is preferably 1% by mass or more, more preferably 1.5% by mass or more, and even more preferably 1.8% by mass or more, and is preferably 5% by mass or less, more preferably 4% by mass or less, even more preferably 3.5% by mass or less, and still even more preferably 3% by mass or less, 2.5% by mass or less, or 2% by mass or less relative to 100% by mass of the component (A). When the amount of Cr is within the above range, the specific magnetic permeability and the magnetic loss of the cured product of the resin composition can effectively be made good.

The mass ratio (Ni/Cr) between the amount of Ni and the amount of Cr contained in the component (A) is preferably 10 or more, more preferably 13 or more, even more preferably 15 or more, still even more preferably 18 or more, and yet still even more preferably 20 or more, 21 or more, 22 or more, or 23 or more, and is preferably 50 or less, more preferably 40 or less, and even more preferably 30 or less. When the ratio (Ni/Cr) between the amount of Ni and the amount of Cr is within the above range, the specific magnetic permeability and the magnetic loss of the cured product of the resin composition can effectively be made good.

When the component (A) contains the Fe-Ni-Si-Cr type alloy magnetic powder, the amount of Si contained in the Fe-Ni-Si-Cr type alloy magnetic powder is preferably less than 1% by mass, more preferably 0.9% by mass or less, and even more preferably 0.8% by mass or less or 0.7% by mass relative to 100% by mass of the component (A). There is no particular limitation on the lower limit of the amount of Si, which may be, for example, 0.1% by mass or more.

The average particles size (D₅₀) of the component (A) is preferably 1 µm or more, more preferably 2 um or more, and even more preferably 3 µm or more. The average particles size (D₅₀) of the component (A) being the above lower limit or more is preferred in view of safety on handling the component (A). Furthermore, when the average particles size (D₅₀) of the component (A) is the above lower limit or more, the magnetic powder containing the component (A) and the component (B) and the resin component containing (C) the thermosetting resin can be mixed together with high uniformity, and thus the uneven presence ratio of the component (A) and the component (B) due to flocculation can effectively be inhibited. Thus, the specific magnetic permeability and the magnetic loss of the cured product can effectively be made good. The upper limit of the average particles size (D₅₀) of the component (A) is preferably 10 µm or less, more preferably 8 um or less, and even more preferably 7 µm or less. When the average particles size (D₅₀) of the component (A) is the above upper limit or less, the particles of the component (A) can be small. Thus, the occurrence of a large eddy-current loss due to giant particles can be inhibited, and thus the magnetic loss can effectively be reduced. This action is effective when the amount of the component (A) is large in particular.

The average particle size (D₅₀) of the component (A) represents a volume-based median diameter unless otherwise specified. This average particle size (D₅₀) can be measured by laser diffraction and scattering based on Mie scattering theory. Specifically, it can be measured by creating particle size distribution on a volume basis with a laser diffraction scattering type particle size distribution analyzer and setting its median diameter as the average particle size (D₅₀). As to a sample to be measured, powder ultrasonically dispersed in water can suitably be used. As the laser diffraction scattering type particle size distribution analyzer, "LA-500" manufactured by Horiba, Ltd., "SALD-2200" manufactured by Shimadzu Corporation, or the like can be used.

The specific surface area of the component (A) is preferably 0.05 m²/g or more, more preferably 0.1 m²/g or more, and even more preferably 0.5 m²/g or more, and is preferably 20 m²/g or less, more preferably 10 m²/g or less, and even more preferably 5 m²/g or less. When the specific surface area of the component (A) is within the above range, the specific magnetic permeability and the magnetic loss of the cured product of the resin composition can effectively be made good. The specific surface area of the magnetic powder can be measured by the BET method. Specifically, the specific surface area can be measured in accordance with the BET method by adsorbing nitrogen gas onto a sample surface using a specific surface area measuring device ("Macsorb HM Model 1210" manufactured by Mountech Co., Ltd.) and using the BET multipoint method.

The particles of the component (A) are preferably spherical or ellipsoidal particles. The value obtained by dividing the length of the major axis of the particles of the component (A) by the length of the minor axis thereof (an aspect ratio) is preferably 2 or less, more preferably 1.6 or less, and even more preferably 1.4 or less. When the aspect ratio of the component (A) is within the above range, the magnetic loss can be reduced and the viscosity of the resin composition can be lowered.

The true density of the component (A) may be in a range of, for example, 4 g/cm³ to 10 g/cm³.

The method for producing the component (A) is not limited. The component (A) can be produced using, for example, the atomization method. In this atomizing method, the component (A) is obtained by a method that usually includes dropping a molten material containing molten iron and nickel, and blowing a highly pressurized water or gas toward the material thereby rapidly cooling down to solidify them. Among the above-mentioned atomizing methods, the water atomizing method, in which water is blown to the dropping molten material, is preferable. As for the atomizing method as described above, for example, the method described in Japanese Patent Application Laid-open No. 2018-178254 may be used.

The content (% by volume) of the component (A) contained in the resin composition is preferably 30% by volume or more, more preferably 40% by volume or more, and even more preferably 45% by volume or more, 47% by volume or more, or 48% by volume or more, and is preferably 70% by volume or less, more preferably 65% by volume or less, and even more preferably 60% by volume or less or 58% by volume or less relative to 100% by volume of the total of the components (A) to (C). When the content of the component (A) is within the above range, the specific magnetic permeability and the magnetic loss of the cured product of the resin composition can effectively be made good. When the content of the component (A) is the upper limit of the above range or less, the resin composition may effectively be lowered in viscosity to be easily made pasty.

The volume-based content (% by volume) of each component contained in the resin composition is determined by calculation from the mass of the component contained in the resin composition. Specifically, the mass is divided by the specific gravity to determine the volume of each component, and from the thus determined volume of each component, the volume-based content (% by mass) can be determined by calculation.

The content (% by mass) of the component (A) contained in the resin composition is preferably 40% by mass or more, more preferably 50% by mass or more, and even more preferably 55% by mass or more, and is preferably 90% by mass or less, more preferably 85% by mass or less, and even more preferably 80% by mass or less relative to 100% by mass of the total of the components (A) to (C). When the content of the component (A) is within the above range, the specific magnetic permeability and the magnetic loss of the cured product of the resin composition can effectively be made good. When the content of the component (A) is the upper limit of the above range or less, the resin composition may effectively be lowered in viscosity to be easily made pasty.

When the resin composition contains a component other than the components (A) to (C), the content (% by volume) of the component (A) contained in the resin composition is preferably 30% by volume or more, more preferably 35% by volume or more, and even more preferably 40% by volume or more or 42% by volume or more, and is preferably 70% by volume or less, more preferably 60% by volume or less, and even more preferably 55% by volume or less relative to 100% by volume of the nonvolatile components contained in the resin composition. When the content of the component (A) is within the above range, the specific magnetic permeability and the magnetic loss of the cured product of the resin composition can effectively be made good. When the content of the component (A) is the upper limit of the above range or less, the resin composition may effectively be lowered in viscosity to be easily made pasty.

When the resin composition contains a component other than the components (A) to (C), the content (% by mass) of the component (A) contained in the resin composition is preferably 40% by mass or more, more preferably 50% by mass or more, and even more preferably 60% by mass or more, and is preferably 85% by mass or less, more preferably 80% by mass or less, and even more preferably 75% by mass or less relative to 100% by mass of the nonvolatile components contained in the resin composition. When the content of the component (A) is within the above range, the specific magnetic permeability and the magnetic loss of the cured product of the resin composition can effectively be made good. When the content of the component (A) is the upper limit of the above range or less, the resin composition may effectively be lowered in viscosity to be easily made pasty.

### (B) Mn-Containing Ferrite Type Magnetic Powder

The resin composition contains (B) the Mn-containing ferrite type magnetic powder as the component (B). The component (B) contains or does not contain a Zn-containing ferrite type magnetic powder. As to (B) the Mn-containing ferrite type magnetic powder, one may be used alone or two or more may be used in combination.

The ferrite type magnetic powder normally contains a composite oxide with iron oxide as a main component and is chemically stable. Thus, the ferrite type magnetic powder provides advantages such as high corrosion resistance, low risk of combustion, and being hard to demagnetize.

Examples of the component (B) include Mn type ferrite powders, Mn-Zn type ferrite powders, Fe-Mn type ferrite powders, Mn-Mg type ferrite powders, and Mn-Mg-Sr type ferrite powders. In the present specification, the term "E₁ type ferrite powder" represents a ferrite powder containing an element E₁, the term "E₁-E₂ type ferrite powder" represents a ferrite powder containing the element E₁ and an element E₂, and the term "E₁-E₂-E₃ type ferrite powder" represents a ferrite powder containing elements E₁, E₂, and E₃. The same applies to ferrite powders containing four or more elements. Note that in the ferrite powder, when Fe is contained in an element such as the element E₁ or the element E₂, Fe means divalent iron, not trivalent iron derived from iron oxide (Fe₂O₃).

The component (B) is preferably one or more ferrite powders selected from the group consisting of a Mn type ferrite powder and a Mn-Zn type ferrite powder. When the range of such a suitable component (B) is defined as a component (B-1), about the mass ratio ((Mn + Zn)/Fe) of a total amount of Mn and Zn to an amount of Fe in an entire magnetic powder contained in the component (A) and the component (B), the amount of Mn and the amount of Zn are preferably derived from the component (B-1). That is, the mass ratio ((Mn + Zn)/Fe) of a total amount of Mn and Zn to an amount of Fe in an entire magnetic powder contained in the component (A) and the component (B-1) is more preferably 0.055 or more and 0.16 or less.

The amount of Fe contained in the component (B) is preferably 33% by mass or more, more preferably 38% by mass or more, and even more preferably 42% by mass or more or 43% by mass or more, and is preferably 70% by mass or less, more preferably 65% by mass or less, and even more preferably 60% by mass or less, 58% by mass or less, or 57% by mass or less relative to 100% by mass of the component (B). When the amount of Fe is within the above range, the specific magnetic permeability and the magnetic loss of the cured product of the resin composition can effectively be made good.

The amount of Mn contained in the component (B) is preferably 5% by mass or more, more preferably 7% by mass or more, and even more preferably 10% by mass or more or 12% by mass or more, and is preferably 35% by mass or less, more preferably 30% by mass or less, and even more preferably 28% by mass or less or 26% by mass or less relative to 100% by mass of the component (B). When the amount of Mn is within the above range, the specific magnetic permeability and the magnetic loss of the cured product of the resin composition can effectively be made good.

When the component (B) is the Mn-Zn type ferrite powder, the amount of Zn contained in the component (B) is preferably 1% by mass or more, more preferably 3% by mass or more, and even more preferably 5% by mass or more or 6% by mass or more, and is preferably 15% by mass or less, more preferably 10% by mass or less, and even more preferably 8% by mass or less or 7% by mass or less relative to 100% by mass of the component (B). When the amount of Zn is within the above range, the specific magnetic permeability and the magnetic loss of the cured product of the resin composition can effectively be made good.

The total amount of Mn and Zn contained in the component (B) is preferably 5% by mass or more, more preferably 7% by mass or more, and even more preferably 10% by mass or more or 12% by mass or more, and is preferably 35% by mass or less, more preferably 30% by mass or less, and even more preferably 28% by mass or less or 26% by mass or less relative to 100% by mass of the component (B). When the amount of Mn and Zn contained in the component (B) is within the above range, the specific magnetic permeability and the magnetic loss of the cured product of the resin composition can effectively be made good.

The component (B) preferably has a smaller average particle size (D₅₀) than (A) the Ni-containing iron alloy type magnetic powder. When the component (B) has a smaller average particle size than (A) the Ni-containing iron alloy type magnetic powder, the component (B) can enter gaps between the particles of the component (A), and thus the magnetic powder can be filled to a high degree, thus making it possible to make magnetic characteristics such as specific magnetic permeability good.

The ratio of the average particle size (D₅₀) of the component (B) to the average particle size (D₅₀) of the component (A) (the average particle size (D₅₀) of the component (B)/the average particle size (D₅₀) of the component (A)) is preferably within a specific range. Specifically, the ratio of the average particle size (D₅₀) (the average particle size (D₅₀) of the component (B)/the average particle size (D₅₀) of the component (A)) is preferably 0.001 or more, more preferably 0.01 or more, and even more preferably 0.05 or more, and is preferably 0.9 or less, more preferably 0.6 or less, and even more preferably 0.3 or less. When the ratio of the average particle size (D₅₀) is within the above range, the specific magnetic permeability and the magnetic loss of the cured product of the resin composition can effectively be made good.

The specific range of the average particle size (D₅₀) of the component (B) is preferably 0.05 µm or more, more preferably 0.1 µm or more, and even more preferably 0.2 µm or more, and is preferably 3 µm or less, more preferably 2 µm or less, and even more preferably 1.5 µm or less. When the average particle size (D₅₀) of the component (B) is the lower limit or more, the viscosity of the resin composition can be lowered. When the average particle size (D₅₀) of the component (B) is the upper limit or less, the specific magnetic permeability and the magnetic loss of the cured product of the resin composition can effectively be made good.

The average particle size (D₅₀) of the component (B) can be measured by the same method as that for the average particle size (D₅₀) of the component (A) .

The component (B) preferably has a larger specific surface area than (A) the Ni-containing iron alloy type magnetic powder. The specific range of the specific surface area of the component (B) is preferably 0.1 m²/g or more, more preferably 1.0 m²/g or more, and even more preferably 2 m²/g or more, and is preferably 40 m²/g or less, more preferably 30 m²/g or less, and even more preferably 20 m²/g or less.

The particles of the component (B) are preferably spherical or ellipsoidal particles. The value obtained by dividing the length of the major axis of the particles of the component (B) by the length of the minor axis thereof (an aspect ratio) is preferably 2 or less, more preferably 1.5 or less, and even more preferably 1.2 or less. When the aspect ratio of the component (B) is within the above range, the magnetic loss can be reduced or the viscosity of the resin composition can be lowered.

The true density of the component (B) may be in a range of, for example, 4 g/cm³ to 10 g/cm³.

The content (% by volume) of the component (B) contained in the resin composition is preferably 15% by volume or more, more preferably 20% by volume or more, and even more preferably 25% by volume or more, and is preferably 60% by volume or less, more preferably 50% by volume or less, and even more preferably 40% by volume or less or 39% by volume or less relative to 100% by volume of the total of the components (A) to (C). When the content of the component (B) is within the above range, the specific magnetic permeability and the magnetic loss of the cured product of the resin composition can effectively be made good.

The content (% by mass) of the component (B) contained in the resin composition is preferably 10% by mass or more, more preferably 15% by mass or more, and even more preferably 20% by mass or more or 21% by mass or more, and is preferably 50% by mass or less, more preferably 40% by mass or less, and even more preferably 35% by mass or less or 34% by mass or less relative to 100% by mass of the total of the components (A) to (C). When the content of the component (B) is within the above range, the specific magnetic permeability and the magnetic loss of the cured product of the resin composition can effectively be made good.

The volume ratio of the component (B) to the component (A) (the content (% by volume) of the component (B)/the content (% by volume) of the component (A)) is preferably within a specific range. Specifically, the volume ratio (the content (% by volume) of the component (B)/the content (% by volume) of the component (A)) is preferably 0.01 or more, more preferably 0.1 or more, and even more preferably 0.3 or more or 0.4 or more, and is preferably 2 or less, more preferably 1.5 or less, and even more preferably 1 or less or 0.9 or less. When the volume ratio (the content (% by volume) of the component (B)/the content (% by volume) of the component (A)) is within the above range, the specific magnetic permeability and the magnetic loss of the cured product of the resin composition can effectively be made good.

The mass ratio of the component (B) to the component (A) (the content (% by mass) of the component (B)/the content (% by mass) of the component (A)) is preferably within a specific range. Specifically, the mass ratio (the content (% by mass) of the component(B)/the content (% by mass) of the component (A)) is preferably 0.01 or more, more preferably 0.1 or more, and even more preferably 0.2 or more or 0.25 or more, and is preferably 1 or less, more preferably 0.7 or less, and even more preferably 0.5 or less. When the mass ratio (the content (% by mass) of the component (B)/the content (% by mass) of the component (A)) is within the above range, the specific magnetic permeability and the magnetic loss of the cured product of the resin composition can effectively be made good.

When the resin composition contains a component other than the components (A) to (C), the content (% by volume) of the component (B) contained in the resin composition is preferably 10% by volume or more, more preferably 15% by volume or more, and even more preferably 20% by volume or more, 22% by volume or more, or 24% by volume or more, and is preferably 50% by volume or less, more preferably 45% by volume or less, and even more preferably 40% by volume or less, 38% by volume or less, or 37% by volume or less relative to 100% by volume of the nonvolatile components contained in the resin composition. When the content of the component (B) is within the above range, the specific magnetic permeability and the magnetic loss of the cured product of the resin composition can effectively be made good. When the content of the component (B) is the upper limit of the above range or less, the resin composition may effectively be lowered in viscosity to be easily made pasty.

When the resin composition contains a component other than the components (A) to (C), the content (% by mass) of the component (B) contained in the resin composition is preferably 10% by mass or more, more preferably 15% by mass or more, and even more preferably 20% by mass or more, and is preferably 45% by mass or less, more preferably 40% by mass or less, and even more preferably 35% by mass or less or 34% by mass or less relative to 100% by mass of the nonvolatile components contained in the resin composition. When the content of the component (B) is within the above range, the specific magnetic permeability and the magnetic loss of the cured product of the resin composition can effectively be made good. When the content of the component (B) is the upper limit of the above range or less, the resin composition may effectively be lowered in viscosity to be easily made pasty.

When the resin composition contains a component other than the components (A) to (C), the total amount (% by volume) of the component (A) and the component (B) contained in the resin composition is preferably 60% by volume or more, more preferably 70% by volume or more, and even more preferably 75% by volume or more or 77% by volume or more, and is preferably 90% by volume or less, more preferably 85% by volume or less, and even more preferably 80% by volume or less or 79% by volume or less relative to 100% by volume of the nonvolatile components contained in the resin composition. When the total amount of the component (A) and the component (B) is within the above range, the specific magnetic permeability and the magnetic loss of the cured product of the resin composition can effectively be made good.

When the resin composition contains a component other than the components (A) to (C), the total amount (% by mass) of the component (A) and the component (B) contained in the resin composition is preferably 70% by mass or more, more preferably 80% by mass or more, and even more preferably 90% by mass or more, 92% by mass or more, or 94% by mass or more, and is preferably 98% by mass or less, more preferably 97% by mass or less, and even more preferably 96% by mass or less relative to 100% by mass of the nonvolatile components contained in the resin composition. When the total amount of the component (A) and the component (B) is within the above range, the specific magnetic permeability and the magnetic loss of the cured product of the resin composition can effectively be made good.

### (C) Thermosetting Resin

The resin composition contains (C) the thermosetting resin as the component (C). (C) The thermosetting resin may bind together the magnetic powder containing (A) the Ni-containing iron alloy type magnetic powder and (B) the Mn-containing ferrite type magnetic powder. In addition, (C) the thermosetting resin may react by heat to form bonds to be cured. Thus, by curing the resin composition containing (A) the Ni-containing iron alloy type magnetic powder, (B) the Mn-containing ferrite type magnetic powder, and (C) the thermosetting resin in combination, a cured product can be obtained. This cured product has excellent specific magnetic permeability and magnetic loss and can thus form an excellent magnetic layer.

Examples of (C) the thermosetting resin include epoxy resins, phenolic resins, active ester type resins, amine type resins, acid anhydride type resins, benzoxazine type resins, cyanate ester type resins, and carbodiimide type resins. As to (C) the thermosetting resin, one may be used alone or two or more may be used in combination.

(C) The thermosetting resin preferably contains (C-1) an epoxy resin. (C-1) The epoxy resin represents a resin having one or more epoxy groups in the molecule. When (C) the thermosetting resin contains (C-1) the epoxy resin, the dispersibility of the magnetic powder such as the component (A) and the component (B) can be improved and the specific magnetic permeability and the magnetic loss of the cured product of the resin composition can effectively be made good.

Examples of (C-1) the epoxy resin include bixylenol type epoxy resins, bisphenol A type epoxy resins; bisphenol F type epoxy resins; bisphenol S type epoxy resins; bisphenol AF type epoxy resins; dicyclopentadiene type epoxy resins; trisphenol type epoxy resins; phenol novolac type epoxy resins; glycidylamine type epoxy resins; glycidyl ester type epoxy resins; cresol novolac type epoxy resins; biphenyl type epoxy resins; linear aliphatic epoxy resins; epoxy resins having a butadiene structure; alicyclic epoxy resins; alicyclic epoxy resins having an ester skeleton; heterocyclic epoxy resins; spirocycle-containing epoxy resins; cyclohexane type epoxy resins; cyclohexane dimethanol type epoxy resins; trimethylol type epoxy resins; tetraphenylethane type epoxy resins; epoxy resins containing a condensed ring skeleton such as naphthylene ether type epoxy resins, tert-butyl-catechol type epoxy resins, naphthalene type epoxy resins, naphthol type epoxy resins, anthracene type epoxy resins, and naphthol novolac type epoxy resins; isocyanurate type epoxy resins; alkyleneoxy skeleton- and butadiene skeleton-containing epoxy resins; and fluorene structure-containing epoxy resins. As to (C-1) the epoxy resin, one may be used alone or two or more may be used in combination.

(C-1) the epoxy resin preferably contains an epoxy resin having two or more epoxy groups in one molecule. The ratio of the epoxy resin having two or more epoxy groups in one molecule is preferably 50% by mass or more, more preferably 60% by mass or more, and even more preferably 70% by mass or more relative to 100% by mass of the entire amount of (C-1) the epoxy resin.

(C-1) the epoxy resin includes an epoxy resin liquid at a temperature of 20°C (hereinafter may be referred to as the "liquid epoxy resin") and an epoxy resin solid at a temperature of 20°C (hereinafter may be referred to as the "solid epoxy resin"). (C-1) the epoxy resin may be only the liquid epoxy resin, only the solid epoxy resin, or a combination of the liquid epoxy resin and the solid epoxy resin. Among them, (C-1) the epoxy resin preferably contains the liquid epoxy resin and more preferably contains only the liquid epoxy resin.

The liquid epoxy resin is preferably a liquid epoxy resin having two or more epoxy groups in one molecule. Preferred examples of the liquid epoxy resin include bisphenol A type epoxy resins, bisphenol F type epoxy resins, bisphenol AF type epoxy resins, naphthalene type epoxy resins, glycidyl ester type epoxy resins, glycidyl amine type epoxy resins, phenol novolac type epoxy resins, alicyclic epoxy resins having an ester skeleton, cyclohexane type epoxy resins, cyclohexanedimethanol type epoxy resins, epoxy resins having a butadiene structure, alkyleneoxy skeleton- and butadiene skeleton-containing epoxy resins, fluorene structure-containing epoxy resins, and dicyclopentadiene type epoxy resins. Among them, bisphenol A type epoxy resins and bisphenol F type epoxy resins are more preferred.

Specific examples of the liquid epoxy resin include "YX7400" manufactured by Mitsubishi Chemical Corporation; "HP4032," "HP4032D," and "HP4032SS" manufactured by DIC Corporation (naphthalene type epoxy resins); "828US," "828EL," "825," and "Epikote 828EL" manufactured by Mitsubishi Chemical Corporation (bisphenol A type epoxy resins); "807" and "1750" manufactured by Mitsubishi Chemical Corporation (bisphenol F type epoxy resins); "152" manufactured by Mitsubishi Chemical Corporation (a phenol novolac type epoxy resin); "630," "630LSD," and "604" manufactured by Mitsubishi Chemical Corporation (glycidyl amine type epoxy resins); "ED-523T" manufactured by ADEKA Corporation (a glycirol type epoxy resin); "EP-3950L" and "EP-3980S" manufactured by ADEKA Corporation (glycidyl amine type epoxy resins); "EP-4088S" manufactured by ADEKA Corporation (a dicyclopentadiene type epoxy resin); "ZX-1059" manufactured by NIPPON STEEL Chemical & Material Co., Ltd. (a mixed product of a bisphenol A type epoxy resin and a bisphenol F type epoxy resin); "EX-721" manufactured by Nagase ChemteX Corporation (a glycidyl ester type epoxy resin); "EX-991L" manufactured by Nagase ChemteX Corporation (an alkyleneoxy skeleton-containing epoxy resin); "Celloxide 2021P" and "Celloxide 2081" manufactured by Daicel Corporation (alicyclic epoxy resins having an ester skeleton); "PB-3600" manufactured by Daicel Corporation and "JP-100" and "JP-200" manufactured by Nippon Soda Co., Ltd. (epoxy resins having a butadiene structure); "ZX-1658" and "ZX-1658GS" manufactured by NIPPON STEEL Chemical & Material Co., Ltd. (liquid 1,4-glycidyl cyclohexane type epoxy resins); and "EG-280" manufactured by Osaka Gas Chemicals Co., Ltd. (a fluorene structure-containing epoxy resin). As to the liquid epoxy resin, one may be used alone or two or more may be used in combination.

The solid epoxy resin is preferably a solid epoxy resin having three or more epoxy groups in one molecule and more preferably an aromatic solid epoxy resin having three or more epoxy groups in one molecule. Preferred examples of the solid epoxy resin include bixylenol type epoxy resins, naphthalene type epoxy resins, naphthalene type tetrafunctional epoxy resins, cresol novolac type epoxy resins, dicyclopentadiene type epoxy resins, trisphenol type epoxy resins, naphthol type epoxy resins, biphenyl type epoxy resins, naphthylene ether type epoxy resins, anthracene type epoxy resins, bisphenol A type epoxy resins, bisphenol AF type epoxy resins, and tetraphenylethane type epoxy resins, and dicyclopentadiene type epoxy resins are more preferred.

Specific examples of the solid epoxy resin include "HP4032H" manufactured by DIC Corporation (a naphthalene type epoxy resin); "HP-4700" and "HP-4710" manufactured by DIC Corporation (naphthalene type tetrafunctional epoxy resins); "N-690" manufactured by DIC Corporation (a cresol novolac type epoxy resin); "N-695" manufactured by DIC Corporation (a cresol novolac type epoxy resin); "HP-7200," "HP-7200 HH," and "HP-7200H" manufactured by DIC Corporation (dicyclopentadiene type epoxy resins); "EXA-7311," "EXA-7311-G3," "EXA-7311-G4," "EXA-7311-G4S," and "HP6000" manufactured by DIC Corporation (naphthylene ether type epoxy resins); "EPPN-502H" manufactured by Nippon Kayaku Co., Ltd. (a trisphenol type epoxy resin); "NC7000L" manufactured by Nippon Kayaku Co., Ltd. (a naphthol novolac type epoxy resin); "NC3000H," "NC3000," "NC3000L," and "NC3100" manufactured by Nippon Kayaku Co., Ltd. (biphenyl type epoxy resins); "ESN475V" manufactured by NIPPON STEEL Chemical & Material Co., Ltd. (a naphthol type epoxy resin); "ESN485" manufactured by NIPPON STEEL Chemical & Material Co., Ltd. (a naphthol novolac type epoxy resin); "YX4000H," "YX4000," and "YL6121" manufactured by Mitsubishi Chemical Corporation (biphenyl type epoxy resins); "YX4000HK" manufactured by Mitsubishi Chemical Corporation (a bixylenol type epoxy resin); "YX8800" manufactured by Mitsubishi Chemical Corporation (an anthracene type epoxy resin); "YX7700" manufactured by Mitsubishi Chemical Corporation (a xylene structure-containing novolac type epoxy resin); "PG-100" and "CG-500" manufactured by Osaka Gas Chemicals Co., Ltd.; "YL7760" manufactured by Mitsubishi Chemical Corporation (a bisphenol AF type epoxy resin); "YL7800" manufactured by Mitsubishi Chemical Corporation (a fluorene type epoxy resin); "1010" manufactured by Mitsubishi Chemical Corporation (a solid biphenol A type epoxy resin); and "1031S" manufactured by Mitsubishi Chemical Corporation (a tetraphenylethane type epoxy resin). As to the solid epoxy resin, one may be used alone or two or more may be used in combination.

When the liquid epoxy resin and the solid resin are used in combination as the epoxy resin, the mass ratio between the liquid epoxy resin and the solid epoxy resin (the liquid epoxy resin/the solid epoxy resin) is preferably 0.5 or more, more preferably 1 or more, even more preferably 5 or more, and still even more preferably 10 or more.

The weight average molecular weight (Mw) of (C-1) the epoxy resin is preferably 100 to 5,000, more preferably 250 to 3,000, and even more preferably 400 to 1,500. The weight average molecular weight of the resin can be measured as a value in terms of polystyrene by gel permeation chromatography (GPC).

The content (% by mass) of the component (C-1) contained in the resin composition is preferably 0.1% by mass or more, more preferably 0.5% by mass or more, and even more preferably 1% by mass or more, and is preferably 10% by mass or less, more preferably 5% by mass or less, and even more preferably 3% by mass or less relative to 100% by mass of the total of the components (A) to (C). When the content of (C-1) the epoxy resin is within the above range, the specific magnetic permeability and the magnetic loss of the cured product of the resin composition can effectively be made good.

When the resin composition contains a component other than the components (A) to (C), the content (% by mass) of the component (C-1) contained in the resin composition is preferably 0.1% by mass or more, more preferably 0.5% by mass or more, and even more preferably 1% by mass or more, and is preferably 10% by mass or less, more preferably 5% by mass or less, and even more preferably 3% by mass or less relative to 100% by mass of the nonvolatile components contained in the resin composition. When the content of (C-1) the epoxy resin is within the above range, the specific magnetic permeability and the magnetic loss of the cured product of the resin composition can effectively be made good.

When the resin composition contains a component other than the components (A) to (C), the content (% by mass) of the component (C-1) contained in the resin composition is preferably 30% by mass or more, more preferably 35% by mass or more, and even more preferably 40% by mass or more, and is preferably 60% by mass or less, more preferably 50% by mass or less, and even more preferably 45% by mass or less, 43% by mass or less, or 42% by mass or less relative to 100% by mass of the resin component contained in the resin composition. When the content of (C-1) the epoxy resin is within the above range, the specific magnetic permeability and the magnetic loss of the cured product of the resin composition can effectively be made good.

When (C) the thermosetting resin contains (C-1) the epoxy resin, (C) the thermosetting resin may contain a resin that may react with and bond to (C-1) the epoxy resin. The resin that may react with and bond to (C-1) the epoxy resin may hereinafter be referred to as "(C-2) a curing agent." Examples of (C-2) the curing agent include phenolic resins, active ester type resins, amine type resins, carbodiimide type resins, acid anhydride type resins, benzoxazine type resins, cyanate ester type resins, and thiol type resins. As to (C-2) the curing agent, one may be used alone or two or more may be used in combination. Among them, phenolic resins are preferred.

As the phenolic resins, resins having one or more, preferably two or more hydroxy groups bonding to an aromatic ring such as a benzene ring or a naphthalene ring in one molecule may be used. From the viewpoint of heat resistance and waterproofing, phenolic resins having a novolac structure are preferred. From the viewpoint of adhesion, nitrogen-containing phenolic resins are preferred, and triazine skeleton-containing phenolic resins are more preferred. Among them, from the viewpoint of satisfying heat resistance, waterproofing, and adhesion to a high degree, triazine skeleton-containing phenol novolac resins are preferred.

Specific examples of the phenolic resins include "MEH-7700," "MEH-7810," "MEH-7851," and "MEH-8000H" manufactured by Meiwa Plastic Industries, Ltd.; "NHN," "CBN," and "GPH" manufactured by Nippon Kayaku Co., Ltd.; "SN-170," "SN-180," "SN-190," "SN-475," "SN-485," "SN-495," "SN-495V," "SN-375," and "SN-395" manufactured by NIPPON STEEL Chemical & Material Co., Ltd.; "TD-2090," "TD-2090-60M," "LA-7052," "LA-7054," "LA-1356," "LA-3018," "LA-3018-50P," "EXB-9500," "HPC-9500," "KA-1160," "KA-1163," and "KA-1165 "manufactured by DIC Corporation; and "GDP-6115L," "GDP-6115H," and "ELPC75" manufactured by Gun Ei Chemical Industry Co., Ltd.

As the active ester type resins, compounds having one or more, preferably two or more active ester groups in one molecule may be used. Among them, as the active ester type resins, preferred are compounds having two or more ester groups having high reaction activity in one molecule, such as phenol esters, thiophenol esters, N-hydroxyamine esters, and esters of heterocyclic hydroxy compounds. The active ester type resins are preferably obtained by a condensation reaction of a carboxylic acid compound and/or a thiocarboxylic acid compound and a hydroxy compound and/or a thiol compound. In particular, from the viewpoint of improving heat resistance, active ester type resins obtained from a carboxylic acid compound and a hydroxy compound are preferred, and active ester type resins obtained from a carboxylic acid compound and a phenol compound and/or a naphthol compound are more preferred. Examples of the carboxylic acid compound include benzoic acid, acetic acid, succinic acid, maleic acid, itaconic acid, phthalic acid, isophthalic acid, terephthalic acid, and pyromellitic acid. Examples of the phenol compound or the naphthol compound include hydroquinone, resorcinol, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadiene type diphenol compounds, and phenol novolac. The "dicyclopentadiene type diphenol compound" refers to a diphenol compound obtained by the condensation of two molecules of phenol to one molecule of dicyclopentadiene.

Preferred specific examples of the active ester type resins include active ester type resins containing a dicyclopentadiene type diphenol structure, active ester type resins containing a naphthalene structure, active ester type resins containing an acetylated product of phenol novolac, and active ester type resins containing a benzoylated product of phenol novolac. Among them, active ester type resins containing a naphthalene structure and active ester type resins containing a dicyclopentadiene type diphenol structure are more preferred. The "dicyclopentadiene type diphenol structure" represents a divalent structural unit containing phenylene-dicyclopentylene-phenylene.

Commercially available products of the active ester type resins include "EXB9451," "EXB9460," "EXB9460S," "HPC-8000-65T,"and "EXB-8000L-65TM" (manufactured by DIC Corporation) as active ester type resins containing a dicyclopentadiene type diphenol structure; "EXB-9416-70BK" and "EXB-8100L-65T" (manufactured by DIC Corporation) as active ester type resins containing a naphthalene structure; "DC808" (manufactured by Mitsubishi Chemical Corporation) as an active ester type resin containing an acetylated product of phenol novolac; "YLH1026" (manufactured by Mitsubishi Chemical Corporation) as an active ester type resin containing a benzoylated product of phenol novolac; "DC808" (manufactured by Mitsubishi Chemical Corporation) as an active ester type resin as an acetylated product of phenol novolac; "YLH1026" (manufactured by Mitsubishi Chemical Corporation), "YLH1030" (manufactured by Mitsubishi Chemical Corporation), and "YLH1048" (manufactured by Mitsubishi Chemical Corporation) as active ester type resins as a benzoylated product of phenol novolac.

As the amine type resins, resins having one or more, preferably two or more amino groups in one molecule may be used. Examples of the amine type resins include aliphatic amines, polyether amines, alicyclic amines, and aromatic amines. Among them, aromatic amines are preferred. The amine type resins are preferably primary amines or secondary amines, and primary amines are more preferred. Specific examples of the amine type resins include 4,4'-methylenebis(2,6-dimethylaniline), diphenyldiaminosulfone, 4,4'-diaminodiphenylmethane, 4,4'-diaminodiphenylsulfone, 3,3'-diaminodiphenylsulfone, m-phenylenediamine, m-xylylenediamine, diethyltoluene diamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl)sulfone, and bis(4-(3-aminophenoxy)phenyl)sulfone. As to the amine type resins, commercially available products may be used, and examples thereof include "KAYABOND C-200S," "KAYABOND C-100," "KAYAHARD A-A," "KAYAHARD A-B," and "KAYAHARD A-S" manufactured by Nippon Kayaku Co., Ltd. and "Epikure W" manufactured by Mitsubishi Chemical Corporation.

As the carbodiimide type resins, resins having one or more, preferably two or more carbodiimide structures in one molecule may be used. Specific examples of the carbodiimide type resins include aliphatic biscarbodiimides such as tetramethylene-bis(t-butylcarbodiimide) and cyclohexane-bis(methylene-t-butylcarbodiimide); biscarbodiimides such as aromatic biscarbodiimides such as phenylene-bis(xylylcarbodiimide); aliphatic polycarbodiimides such as polyhexamethylenecarbodiimide, polytrimethylhexamethylenecarbodiimide, polycyclohexylenecarbodiimide, poly(methylenebiscyclohexylenecarbodiimide), and poly(isophoronecarbodiimide); and polycarbodiimides such as aromatic polycarbodiimides such as poly(phenylenecarbodiimide), poly(naphthylenecarbodiimide), poly(tolylenecarbodiimide), poly(methyldiisopropylphenylenecarbodiimide), poly(triethylphenylenecarbodiimide), poly(diethylphenylenecarbodiimide), poly(triisopropylphenylenecarbodiimide), poly(diisopropylphenylenecarbodiimide), poly(xylylenecarbodiimide), Poly(tetramethylxylylenecarbodiimide), poly(methylenediphenylenecarbodiimide), and poly[methylenebis(methylphenylene)carbodiimide]. Commercially available products of the carbodiimide type resins include "Carbodilite V-02B," "Carbodilite V-03," "Carbodilite V-04K," "Carbodilite V-07," and "Carbodilite V-09" manufactured by Nisshinbo Chemical Inc.; and "Stabaxol P," "Stabaxol P400," and "Hycasyl 510" manufactured by Lanxess.

As the acid anhydride type resins, resins having one or more acid anhydride groups in one molecule can be used, and resins having two or more acid anhydride groups in one molecule are preferred. Specific examples of the acid anhydride type resins include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), and polymer type acid anhydrides such as styrene-maleic acid resins in which styrene and maleic acid are copolymerized. Commercially available products of the acid anhydride type resins include "HNA-100," "MH-700," "MTA-15," "DDSA," and "OSA" manufactured by New Japan Chemical Co., Ltd.; "YH-306" and "YH-307" manufactured by Mitsubishi Chemical Corporation; "HN-2200" and "HN-5500" manufactured by Resonac Corporation; and "EF-30," "EF-40," "EF-60," and "EF-80" manufactured by Cray Valley.

Specific examples of the benzoxazine type resins include "JBZ-OD100," "JBZ-OP100D," and "ODA-BOZ" manufactured by JFE Chemical Corporation; "P-d" and "F-a" manufactured by Shikoku Chemicals Corporation; and "HFB2006M" manufactured by Showa Highpolymer Co., Ltd.

Examples of the cyanate ester type resins include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidenediphenyldicyanate, hexafluorobisphenol A dicyanate, 2,2-bis(4-cyanate)phenylpropane, 1,1-bis(4-cyanatophenyl)methane, bis(4-cyanate-3,5-dimethylphenyl)methane, 1,3-bis(4-cyanatophenyl-1-(methylethylidene))benzene, bis(4-cyanatophenyl)thioether, and bis(4-cyanatophenyl)ether; polyfunctional cyanate resins derived from phenol novolac, cresol novolac, and the like; and prepolymers in which these cyanate resins partially become triazine. Specific examples of the cyanate ester type resins include "PT30" and "PT60" (phenol novolac type polyfunctional cyanate ester resins), "ULL-950S" (a polyfunctional cyanate ester resin), and "BA230" and "BA230S75" (prepolymers in which part or all of bisphenol A dicyanate becomes triazine to become trimers) manufactured by Arxada.

Examples of the thiol type resins include trimethylolpropane tris(3-mercaptopropionate), pentaerythritol tetrakis(3-mercaptobutyrate), and tris(3-mercaptopropyl)isocyanurate.

The active group equivalent of (C-2) the curing agent is preferably 50 g/eq. to 3,000 g/eq., more preferably 100 g/eq. to 1,000 g/eq., even more preferably 100 g/eq. to 500 g/eq., and still even more preferably 100 g/eq. to 300 g/eq. The active group equivalent represents the mass of (C-2) the curing agent per equivalent of an active group.

When the number of epoxy groups of (C-1) the epoxy resin is 1, the number of active groups of (C-2) the curing agent is preferably 0.01 or more, more preferably 0.1 or more, and even more preferably 0.5 or more, and is preferably 10 or less, more preferably 5 or less, and even more preferably 3 or less. The active group of (C-2) the curing agent is an active hydroxy group or the like, which varies by the type of the curing agent. The number of epoxy groups of (C-1) the epoxy resin is a value obtained by totaling a value obtained by dividing the nonvolatile component mass of each epoxy resin by the epoxy equivalent for all the epoxy resins. The number of active groups of (C-2) the curing agent is a value obtained by totaling a value obtained by dividing the nonvolatile component mass of each curing agent by the active group equivalent for all the curing agents.

The content (% by mass) of the component (C-2) contained in the resin composition is preferably 0.1% by mass or more, more preferably 0.5% by mass or more, and even more preferably 1% by mass or more, and is preferably 10% by mass or less, more preferably 5% by mass or less, and even more preferably 3% by mass or less relative to 100% by mass of the total of the components (A) to (C). When the content of (C-2) the curing agent is within the above range, the specific magnetic permeability and the magnetic loss of the cured product of the resin composition can effectively be made good.

When the resin composition contains a component other than the components (A) to (C), the content (% by mass) of the component (C-2) contained in the resin composition is preferably 0.1% by mass or more, more preferably 0.5% by mass or more, and even more preferably 1% by mass or more, and is preferably 10% by mass or less, more preferably 5% by mass or less, and even more preferably 3% by mass or less relative to 100% by mass of the nonvolatile components contained in the resin composition. When the content of (C-2) the curing agent is within the above range, the specific magnetic permeability and the magnetic loss of the cured product of the resin composition can effectively be made good.

When the resin composition contains a component other than the components (A) to (C), the content (% by mass) of the component (C-2) contained in the resin composition is preferably 15% by mass or more, more preferably 20% by mass or more, and even more preferably 25% by mass or more or 27% by mass or more, and is preferably 40% by mass or less, more preferably 35% by mass or less, and even more preferably 30% by mass or less or 29% by mass or less relative to 100% by mass of the resin component contained in the resin composition. When the content of (C-2) the curing agent is within the above range, the specific magnetic permeability and the magnetic loss of the cured product of the resin composition can effectively be made good.

The range of the weight average molecular weight (Mw) of (C) the thermosetting resin may normally be the same as the range of the weight average molecular weight of (C-1) the epoxy resin described above.

The content (% by mass) of the component (C) contained in the resin composition is preferably 0.1% by mass or more, more preferably 1% by mass or more, and even more preferably 3% by mass or more, and is preferably 10% by mass or less, more preferably 7% by mass or less, and even more preferably 5% by mass or less relative to 100% by mass of the total of the components (A) to (C). When the content of (C) the thermosetting resin is within the above range, the specific magnetic permeability and the magnetic loss of the cured product of the resin composition can effectively be made good.

When the resin composition contains a component other than the components (A) to (C), the content (% by mass) of the component (C) contained in the resin composition is preferably 0.1% by mass or more, more preferably 1% by mass or more, and even more preferably 2% by mass or more or 2.5% by mass or more, and is preferably 10% by mass or less, more preferably 7% by mass or less, and even more preferably 5% by mass or less relative to 100% by mass of the nonvolatile components contained in the resin composition. When the content of (C) the thermosetting resin is within the above range, the specific magnetic permeability and the magnetic loss of the cured product of the resin composition can effectively be made good.

When the resin composition contains a component other than the components (A) to (C), the content (% by mass) of the component (C) contained in the resin composition is preferably 50% by mass or more, more preferably 60% by mass or more, and even more preferably 65% by mass or more or 68% by mass or more, and is preferably 80% by mass or less, more preferably 75% by mass or less, and even more preferably 70% by mass or less relative to 100% by mass of the resin component contained in the resin composition. When the content of (C) the thermosetting resin is within the above range, the specific magnetic permeability and the magnetic loss of the cured product of the resin composition can effectively be made good.

### (D) Optional Magnetic Powder (Magnetic Powder other than Component (A) and Component (B))

The resin composition may further contain (D) a magnetic powder other than the component (A) and the component (B) as an optional component in combination with the components (A) to (C) described above. "(D) The magnetic powder other than the component (A) and the component (B)" as the component (D) may be referred to as "(D) the optional magnetic powder" as appropriate.

As (D) the optional magnetic powder, particles of a material having a specific magnetic permeability of greater than 1 may be used. The material of (D) the optional magnetic powder is normally an inorganic material and may be a soft magnetic material or a hard magnetic material. As to the material of (D) the optional magnetic powder, one may be used alone or two or more may be used in combination. Thus, (D) the optional magnetic powder may be a soft magnetic powder, a hard magnetic powder, or a combination of the soft magnetic powder and the hard magnetic powder. As to (D) the optional magnetic powder, one may be used alone or two or more may be used in combination. In particular, (D) the optional magnetic powder preferably contains the soft magnetic powder and more preferably contains only the soft magnetic powder.

Examples of (D) the optional magnetic powder include magnetic metal oxide powders and magnetic metallic powders.

Examples of the magnetic metal oxide powders include ferrite type magnetic powders; and iron oxide powders such as iron oxide powders (III) and triiron tetraoxide powders.

Examples of the ferrite type magnetic powders include Mg-Zn type ferrite powders, Mg-Sr type ferrite powders, Cu-Zn type ferrite powders, Ni-Zn type ferrite powders, Ni-Zn-Cu type ferrite powders, Ba-Zn type ferrite powders, Ba-Mg type ferrite powders, Ba-Ni type ferrite powders, Ba-Co type ferrite powders, Ba-Ni-Co type ferrite powders, and Y type ferrite powders.

Examples of the magnetic metallic powders include pure iron powders; crystalline or amorphous alloy magnetic powders such as Fe-Si type alloy powders, Fe-Si-Al type alloy powders, Fe-Cr type alloy powders, Fe-Cr-Si type alloy powders, Fe-Cr-Al type alloy powders, Fe-Co type alloy powders, and Co-based amorphous alloy powders; and amorphous alloys such as Co-based amorphous.

When the resin composition contains (D) the optional magnetic powder, the content (% by volume) of the component (D) contained in the resin composition is preferably 20% by volume or less, more preferably 10% by volume or less, even more preferably 5% by volume or less, and still even more preferably 3% by volume or less relative to 100% by volume of the nonvolatile components of the resin composition. The lower limit of the content (% by volume) of the component (D) may be 0% by volume or greater than 0% by volume. Among them, the lower limit of the content (% by volume) of the component (D) is preferably 0% by volume. When the content (% by volume) of (D) the optional magnetic powder is within the above range, the specific magnetic permeability and the magnetic loss of the cured product of the resin composition can effectively be made good.

When the resin composition contains (D) the optional magnetic powder, the amount (% by mass) of (D) the optional magnetic powder contained in the resin composition is preferably 30% by mass or less, more preferably 15% by mass or less, even more preferably 7.5% by mass or less, and still even more preferably 5% by mass or less relative to 100% by mass of the nonvolatile components of the resin composition. The lower limit of the content (% by mass) of the component (D) may be 0% by mass or greater than 0% by mass. Among them, the lower limit of the content (% by mass) of the component (D) is preferably 0% by mass. When the content (% by mass) of (D) the optional magnetic powder is within the above range, the specific magnetic permeability and the magnetic loss of the cured product of the resin composition can effectively be made good.

### (E) Thermoplastic Resin

The resin composition may further contain (E) a thermoplastic resin as an optional component in combination with the components (A) to (D) described above. (E) The thermoplastic resin as the (E) component does not include those corresponding to the components (A) to (D) described above. (E) The thermoplastic resin can effectively improve the mechanical characteristics of the cured products of the resin composition.

Examples of (E) the thermoplastic resin include phenoxy resins, polyimide resins, polyvinyl acetal resins, polyolefin resins, polybutadiene resins, polyamideimide resins, polyetherimide resins, polysulfone resins, polyethersulfone resins, polyphenylene ether resins, polycarbonate resins, polyetheretherketone resins, and polyester resins. As to (E) the thermoplastic resin, one may be used alone or two or more may be used in combination.

Examples of the phenoxy resins include phenoxy resins having one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The end of the phenoxy resins may be any functional group such as a phenolic hydroxy group or an epoxy group. Specific examples of the phenoxy resins include "1256" and "4250" manufactured by Mitsubishi Chemical Corporation (both are phenoxy resins containing a bisphenol A skeleton); "YX8100" manufactured by Mitsubishi Chemical Corporation (a phenoxy resin containing a bisphenol S skeleton); "YX6954" manufactured by Mitsubishi Chemical Corporation (a phenoxy resin containing a bisphenol acetophenone skeleton); "FX280" and "FX293" manufactured by NIPPON STEEL Chemical & Material Co., Ltd.; and "YL7500BH30," "YX6954BH30," "YX7553," "YX7553BH30," "YL7769BH30," "YL6794," "YL7213," "YL7290," "YL7482," and "YL7891BH30" manufactured by Mitsubishi Chemical Corporation.

Specific examples of the polyimide resins include "SLK-6100" manufactured by Shin-Etsu Chemical Co., Ltd. and "Rikacoat SN20" and "Rikacoat PN20" manufactured by New Japan Chemical Co., Ltd. Specific examples of the polyimide resins also include modified polyimides such as a linear polyimide obtained by reacting a bifunctional hydroxy group-terminated polybutadiene, a diisocyanate compound, and a tetrabasic acid anhydride (the polyimide described in Japanese Patent Application Laid-open No. 2006-37083) and polysiloxane skeleton-containing polyimides (the polyimides described in Japanese Patent Application Laid-open No. 2002-12667, Japanese Patent Application Laid-open No. 2000-319386, and the like).

Examples of the polyvinyl acetal resins includes polyvinylformal resins and polyvinyl butyral resins, and polyvinyl butyral resins are preferred. Specific examples of the polyvinyl acetal resins include the S-LEC BH series, BX series (for example, BX-5Z), KS series (for example, KS-1), BL series, and BM series manufactured by Sekisui Chemical Co., Ltd.

Examples of the polyolefin resins include low-density polyethylenes, ultralow-density polyethylenes, high-density polyethylenes, ethylene type copolymer resins such as ethylene-vinyl acetate copolymers, ethylene-ethyl acrylate copolymers, and ethylene-methyl acrylate copolymers; polyolefin type polymers such as polypropylenes and ethylene-propylene block copolymers.

Examples of the polybutadiene resins include hydrogenated polybutadiene skeleton-containing resins, hydroxy group-containing polybutadiene resins, phenolic hydroxy group-containing polybutadiene resins, carboxy group-containing polybutadiene resins, acid anhydride group-containing polybutadiene resins, epoxy group-containing polybutadiene resins, isocyanate group-containing polybutadiene resins, urethane group-containing polybutadiene resins, and polyphenylene ether-polybutadiene resins.

Specific examples of the polyamideimide resins include "Vylomax HR11NN" and "Vylomax HR16NN" manufactured by Toyobo Co., Ltd. Specific examples of the polyamideimide resins also include modified polyamideimides such as "KS9100" and "KS9300" manufactured by Hitachi Chemical Co., Ltd. (polyamide imide containing a polysiloxane skeleton).

Specific examples of the polyethersulfone resins include "PES5003P" manufactured by Sumitomo Chemical Co., Ltd.

Specific examples of the polysulfone resins include Polysulfone "P1700" and "P3500" manufactured by Solvay Advanced Polymers, Inc.

Specific examples of the polyphenylene ether resins include "NORYL SA90" manufactured by SABIC. Specific examples of the polyetherimide resins include "Ultem" manufactured by General Electric Company.

Examples of the polycarbonate resins include hydroxy group-containing carbonate resins, phenolic hydroxy group-containing carbonate resins, carboxy group-containing carbonate resins, acid anhydride group-containing carbonate resins, isocyanate group-containing carbonate resins, and urethane group-containing carbonate resins. Specific examples of the polycarbonate resins include "FPC0220" manufactured by Mitsubishi Gas Chemical Company, Inc., "T6002" and "T6001" manufactured by Asahi Kasei Corporation (polycarbonate diols), and "C-1090," "C-2090," and "C-3090" manufactured by Kuraray Co., Ltd. (polycarbonate diols). Specific examples of the polyetheretherketone resins include "Sumiploy K" manufactured by Sumitomo Chemical Co., Ltd.

Examples of the polyester resins include polyethylene terephthalate resins, polyethylene naphthalate resins, polybutylene terephthalate resins, polybutylene naphthalate resins, polytrimethylene terephthalate resins, polytrimethylene naphthalate resins, and polycyclohexanedimethyl terephthalate resins.

The weight average molecular weight (Mw) of (E) the thermoplastic resin is preferably greater than 5,000, more preferably 8,000 or more, even more preferably 10,000 or more, and still even more preferably 20,000 or more. There is no particular limitation on the upper limit thereof, which may be, for example, 1,000,000 or less, 500,000 or less, or 100,000 or less.

When the resin composition contains (E) the thermoplastic resin, the content (% by mass) of the component (E) contained in the resin composition is preferably 0.01% by mass or more, more preferably 0.05% by mass or more, and even more preferably 0.1% by mass or more, and is preferably 5% by mass or less, more preferably 3% by mass or less, and even more preferably 1% by mass or less relative to 100% by mass of the nonvolatile components of the resin composition. When the amount of (E) the thermoplastic resin is within the above range, the specific magnetic permeability and the magnetic loss of the cured product of the resin composition can effectively be made good.

When the resin composition contains (E) the thermoplastic resin, the content (% by mass) of the component (E) contained in the resin composition is preferably 1% by mass or more, more preferably 5% by mass or more, and even more preferably 10% by mass or more, and is preferably 25% by mass or less, more preferably 20% by mass or less, and even more preferably 15% by mass or less relative to 100% by mass of the resin component of the resin composition. When the amount of (E) the thermoplastic resin is within the above range, the specific magnetic permeability and the magnetic loss of the cured product of the resin composition can effectively be made good.

### (F) Curing Accelerator

The resin composition may further contain (F) a curing accelerator as an optional component in combination with the components (A) to (E) described above. (F) The curing accelerator as the component (F) does not include those corresponding to the components (A) to (E) described above. (F) The curing accelerator has a function as a catalyst of the reaction of (B) the thermosetting resin and can thus accelerate the curing of the resin composition.

Examples of (F) the curing accelerator include imidazole type curing accelerators, phosphorus type curing accelerators, amine type curing accelerators, guanidine type curing accelerators, metallic curing accelerators, and urea type curing accelerators. As to (F) the curing accelerator, one may be used alone or two or more may be used in combination. Among them, as (F) the curing accelerator, the imidazole type curing accelerators and the phosphorus type curing accelerators are preferred, and the imidazole type curing accelerators are more preferred.

Examples of the imidazole type curing accelerators include imidazole compounds and adducts of imidazole compounds and epoxy resins such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline, and 2-ethyl-4-methylimidazole and 1-benzyl-2-phenylimidazole are preferred. As to the imidazole type curing accelerators, commercially available products may be used, and examples thereof include "P200-H50" manufactured by Mitsubishi Chemical Corporation; and "Curezol 2MZ," "2E4MZ," "Cl1Z," "Cl1Z-CN," "Cl1Z-CNS," "Cl1Z-A," "2MZ-OK," "2MA-OK," "2MA-OK-PW," "2MZA-PW," "2PHZ," "2PHZ-PW," "1B2PZ," and "1B2PZ-10M" manufactured by Shikoku Chemicals Corporation.

Examples of the phosphorus type curing accelerators include phosphonium salts and phosphines. Examples of the phosphonium salts include aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, n-butylphosphonium tetraphenylborate, bis(tetrabutylphosphonium)pyromellitate, tetrabutylphosphonium hydrogen hexahydrophthalate, tetrabutylphosphonium 2,6-bis[(2-hydroxy-5-methylphenyl)methyl]-4-methylphenolate, and di-tert-butylmethylphosphonium tetraphenylborate; and aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate.

Examples of the phosphines include aliphatic phosphines such as tributylphosphine, tri-tert-butylphosphine, trioctylphosphine, di-tert-butyl(2-butenyl)phosphine, di-tert-butyl(3-methyl-2-butenyl)phosphine, and tricyclohexyl phosphine; aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl)phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl)phosphine, tris(2,4,6-trimethylphenyl)phosphine, tris(2,6-dimethyl-4-ethoxyphenyl)phosphine, tris(2-methoxyphenyl)phosphine, tris(4-methoxyphenyl)phosphine, tris(4-ethoxyphenyl)phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenyl ether; aromatic phosphine borane complexes such as triphenylphosphine triphenylborane; and aromatic phosphine quinone addition reaction products such as triphenylphosphine p-benzoquinone addition reaction products.

As to the phosphorus type curing accelerators, commercially available products may be used, and examples thereof include "TBP-DA" manufactured by Hokko Chemical Industry Co., Ltd.

Examples of the amine type curing accelerators include trialkylamines such as triethylamine and tributylamine, 4-dimethylaminopyridine, benzyl dimethylamine, 2,4,6-tris(dimethylaminomethyl)phenol, 1,8-diazabicyclo[5,4,0]undecene, 1,8-diazabicyclo[5,4,0]undecene-7,4-dimethylaminopyridine, and 2,4,6-tris(dimethylaminomethyl)phenol, and 4-dimethylaminopyridine is preferred. As to the amine type curing accelerators, commercially available products may be used, and examples thereof include "PN-50," "PN-23," and "MY-25" manufactured by Ajinomoto Fine-Techno Co., Inc.

Examples of the guanidine type curing accelerators include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide, and dicyandiamide and 1,5,7-triazabicyclo[4.4.0]dec-5-ene are preferred.

Examples of the metallic curing accelerators include organometallic complexes or organometallic salts of metals such as cobalt, copper, zinc, iron, nickel, manganese, and tin. Specific examples of the organometallic complexes include organocobalt complexes such as cobalt(II) acetylacetonate and cobalt(III) acetylacetonate, organocopper complexes such as copper(II) acetylacetonate, organozinc complexes such as zinc(II) acetylacetonate, organoiron complexes such as iron(III) acetylacetonate, organonickel complexes such as nickel(II) acetylacetonate, and organomanganese complexes such as manganese(II) acetylacetonate. Examples of the organometallic salts include zinc octylate, tin octylate, zinc naphthenate, cobalt naphthenate, tin stearate, and zinc stearate.

Examples of the urea type curing accelerators include aliphatic dimethylureas such as 1,1-dimethylurea, 1,1,3-trimethylurea, 3-ethyl-1,1-dimethylurea, 3-cyclohexyl-1,1-dimethylurea, and 3-cyclooctyl-1,1-dimethylurea; aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene)bis(N',N'-dimethylurea), and N,N-(4-methyl-1,3-phenylene)bis(N',N'-dimethylurea) [toluene bis(dimethylurea)].

When the resin composition contains (F) the curing accelerator, the content (% by mass) of the component (F) contained in the resin composition is preferably 0.001% by mass or more, more preferably 0.005% by mass or more, and even more preferably 0.01% by mass or more, and is preferably 2% by mass or less, more preferably 1% by mass or less, and even more preferably 0.1% by mass or less relative to 100% by mass of the nonvolatile components of the resin composition. When the content of (F) the curing accelerator is within the above range, the specific magnetic permeability and the magnetic loss of the cured product of the resin composition can effectively be made good.

When the resin composition contains (F) the curing accelerator, the content (% by mass) of the component (F) contained in the resin composition is preferably 0.01% by mass or more, more preferably 0.1% by mass or more, and even more preferably 0.2% by mass or more, and is preferably 3% by mass or less, more preferably 1% by mass or less, and even more preferably 0.5% by mass or less relative to 100% by mass of the resin component of the resin composition. When the content of (F) the curing accelerator is within the above range, the specific magnetic permeability and the magnetic loss of the cured product of the resin composition can effectively be made good.

### (G) Dispersant

The resin composition may further contain (G) a dispersant as an optional component in combination with the components (A) to (F) described above. (G) The dispersant as the component (G) does not include those corresponding to the components (A) to (F) described above. (G) The dispersant can increase the dispersibility of the magnetic powder containing (A) the Ni-containing iron alloy type magnetic powder and (B) the Mn-containing ferrite type magnetic powder (and (D) the optional magnetic powder).

The type of (G) the dispersant is not limited. For example, as (G) the dispersant, one containing a functional group having adsorptivity to the magnetic powder and dispersing the magnetic powder through repulsion (for example, electrostatic repulsion, steric repulsion, or the like) between (G) the dispersant when adsorbing to the magnetic powder may be used. Examples of such (G) a dispersant include acidic dispersants and basic dispersants.

The acidic dispersants normally contain acidic functional groups such as a carboxy group, a sulfo group (-SO₃H), a sulfate group (-OSO₃H), a phosphono group (-PO(OH)₂), a phosphonooxy group (-OPO(OH)₂), a hydroxyphosphoryl group (-PO(OH)-), and a sulfanyl group (-SH). The acidic functional groups normally have dissociable protons and may be neutralized by bases such as amines and hydroxide ions. Preferred examples of the acidic dispersants include acidic polymer dispersants containing polymer chains such as polyoxyalkylene chains and polyether chains. Preferred examples of the acidic dispersants include "C-2093I" and "SC-1015F" manufactured by NOF Corporation (multifunctional comb type functional polymers having ionic groups in the main chain and polyoxyalkylene chains in the graft chains); "ED152," "ED153," "ED154," "ED118," "ED174, "ED251," and "DA-375" manufactured by Kusumoto Chemicals, Ltd. (polyether type phosphate type dispersants); "RS-410," "RS-610," and "RS-710 of the "Phosphanol" series (pH: 1.9) manufactured by Toho Chemical Industry Co., Ltd. (phosphate type dispersants); and "AKM-0531," "AFB-1521," "SC-0505K," and "SC-0708A" of the MALIALIM series manufactured by NOF Corporation.

The basic dispersants normally contain basic functional groups such as primary, secondary, and tertiary amino groups; an ammonium group; an imino group; and nitrogen-containing heterocyclic groups such as pyridine, pyrimidine, pyrazine, imidazole, and triazole. The basic functional groups may be neutralized by acids such as organic acids and inorganic acids. Preferred examples of the basic dispersants include basic polymer dispersants containing polymer chains such as polyester chains. Preferred examples of the basic dispersants include "PB-881" manufactured by Ajinomoto Fine-Techno Co., Inc. (a polyamine type dispersant containing polyester chains).

As to (G) the dispersant, one may be used alone or two or more may be used in combination.

When the resin composition contains (G) the dispersant, the content (% by mass) of the component (G) contained in the resin composition is preferably 0.01% by mass or more, more preferably 0.1% by mass or more, and even more preferably 0.5% by mass or more, and is preferably 5% by mass or less, more preferably 3% by mass or less, and even more preferably 1% by mass or less relative to 100% by mass of the nonvolatile components of the resin composition. When the content of (G) the dispersant is within the above range, the specific magnetic permeability and the magnetic loss of the cured product of the resin composition can effectively be made good.

When the resin composition contains (G) the dispersant, the content (% by mass) of the component (G) contained in the resin composition is preferably 5% by mass or more, more preferably 10% by mass or more, and even more preferably 15% by mass or more, and is preferably 30% by mass or less, more preferably 25% by mass or less, and even more preferably 20% by mass or less relative to 100% by mass of the resin component of the resin composition. When the content of (G) the dispersant is within the above range, the specific magnetic permeability and the magnetic loss of the cured product of the resin composition can effectively be made good.

### (H) Optional Additive

The resin composition may further contain (H) an optional additive as an optional component in combination with the components (A) to (G) described above. (H) The optional additive as the component (H) does not include those corresponding to the components (A) to (G) described above.

Examples of (H) the optional additive include radical polymerizable compounds such as maleimide type radical polymerizable compounds, vinylphenyl type radical polymerizable compounds, (meth)acrylic radical polymerizable compounds, allyl type radical polymerizable compounds, and polybutadiene type radical polymerizable compounds; radical polymerization initiators such as peroxide type radical polymerization initiators and azo type radical polymerization initiators; inorganic fillers such as silica particles; organic fillers such as rubber particles; organometallic compounds such as organocopper compounds and organozinc compounds; polymerization inhibitors such as hydroquinone, catechol, pyrogallol, and phenothiazine; leveling agents such as silicone type leveling agents and acrylic polymer type leveling agents; thickening agents such as Bentone and montmorillonite; defoaming agents such as silicone type defoaming agents, acrylic defoaming agents, fluorine type defoaming agents, and vinyl resin type defoaming agents; UV absorbers such as benzotriazole type UV absorbers; adhesion improvers such as urea silane, adhesion imparting agents such as triazole type adhesion imparting agents, tetrazole type adhesion imparting agents, and triazine type adhesion imparting agents; antioxidants such as hindered phenol type antioxidants; flame retardants such as phosphorus type flame retardants (for example, phosphate compounds, phosphazene compounds, phosphinic acid compounds, and red phosphorus), nitrogen type flame retardants (for example, melamine sulfate), halogen type flame retardants, and inorganic flame retardants (for example, antimony trioxide); and stabilizers such as borate type stabilizers, titanate type stabilizers, aluminate type stabilizers, zirconate type stabilizers, isocyanate type stabilizers, carboxylic acid type stabilizers, and carboxylic acid anhydride type stabilizers. As to (H) the optional additive, one may be used alone or two or more may be used in combination.

### (I) Solvent

The resin composition may further contain (I) a solvent as a volatile component in combination with the nonvolatile components such as the components (A) to (H) described above.

As (I) the solvent, organic solvents are normally used. Examples of (I) the solvent include ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethylene glycol; ether ester type solvents such as 2-ethoxyethyl acetate, propylene glycol monomethyl ether acetate, diethylene glycol monoethyl ether acetate, ethyl diglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propylene glycol monomethyl ether, and diethylene glycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. As to (I) the solvent, one may be used alone or two or more may be used in combination.

The content of (I) the solvent is preferably set such that the melt viscosity of the resin composition can be adjusted to an appropriate range. The content of (I) the solvent may be, for example, 3% by mass or less, 1% by mass or less, 0.5% by mass or less, 0.1% by mass or less, or 0.01% by mass or less relative to 100% by mass of the nonvolatile components in the resin composition. When the content of (I) the solvent contained in the resin composition is small, the generation of voids due to the volatilization of (I) the solvent can be inhibited, and furthermore, the handleability and workability of the resin composition can be improved.

### Characteristics and Uses of Resin Composition

The resin composition described above can be cured by heat. Thus, the cured product of the resin composition can be obtained by thermally curing the resin composition. Normally, among the components contained in the resin composition, volatile components such as (I) the solvent may be volatilized by heat during thermal curing, but nonvolatile components such as the components (A) to (H) are not volatilized by heat during thermal curing. Thus, the cured product of the resin composition may contain the nonvolatile components of the resin composition or reaction products thereof.

Thus, the above resin composition can produce a cured product having a high specific magnetic permeability. For example, when the specific magnetic permeability of the cured product obtained by thermally curing the resin composition at 190°C for 90 minutes is measured under the conditions at a measurement frequency of 20 MHz and a room temperature of 23°C, the specific magnetic permeability is preferably 23 or more, more preferably 23.5 or more, and even more preferably 23.7 or more. There is no particular limitation on the upper limit of the specific magnetic permeability, which may be, for example, 35 or less or 30 or less. The specific magnetic permeability of the cured product can be measured by the method described in examples described below.

The above resin composition can also produce a cured product having a low magnetic loss. The magnetic loss can be expressed by the loss factor tanδ. Usually, the smaller the magnetic loss tangent tanδ is, the smaller the magnetic loss is. For example, when the loss factor tanδ of the cured product obtained by thermally curing the resin composition at 190°C for 90 minutes is measured under the conditions at a measurement frequency of 20 MHz and a room temperature of 23°C, the loss factor tanδ is preferably 0.04 or less, more preferably 0.035 or less, and even more preferably 0.033 or less. There is no particular limitation on the lower limit of the loss factor, which may be, for example, 0.00001 or more. The loss factor tanδ of the cured product can be measured by the method described in the examples described below.

There is no particular limitation on the properties of the resin composition. Thus, the resin composition may be in solid form or in pasty form having flowability. For example, the resin composition may be a pasty resin composition using a solvent or a pasty resin composition using a liquid thermosetting resin such as a liquid epoxy resin. When the content of the solvent in the resin composition is small, the generation of voids due to the volatilization of the solvent can be inhibited, and furthermore, excellent handleability and workability can be achieved.

Taking advantage of the excellent characteristics described above, the resin composition is preferably used as a resin composition for inductor production. For example, the resin composition described above is preferably used as a hole-filling resin composition for being filled in holes in a substrate included in a circuit board. For example, the resin composition described above is also preferably used to form a cured product layer in the circuit board. To facilitate application to these uses, the resin composition may be used in a pasty form or used in the form of a resin sheet containing a layer of the resin composition.

### Production Method of Resin Composition

The resin composition can be produced by, for example, mixing together the components described above. Part or all of the components described above may be mixed together simultaneously or mixed together sequentially. In the process of mixing together the components, the temperature may be set as appropriate, and thus, heating and/or cooling may be performed temporarily or throughout the process. In addition, in the process of mixing together the components, stirring or shaking may be performed. Furthermore, defoaming may be performed under low-pressure conditions such as under a vacuum.

### Magnetic Paste

The magnetic paste of the present invention contains the resin composition described above. The magnetic paste is normally a fluid paste containing the resin composition and may preferably be used for filling holes by printing. This magnetic paste may contain only the resin composition described above or contain any components in combination with the resin composition. Preferably, the pasty resin composition itself can be used as the magnetic paste.

The magnetic paste is preferably pasty at 23°C. The viscosity of this magnetic paste is preferably 20 Pa·s or more, more preferably 25 Pa·s or more, even more preferably 30 Pa·s or more, and still even more preferably 50 Pa·s or more, and is preferably 200 Pa·s or less, more preferably 180 Pa·s or less, and even more preferably 160 Pa·s or less at 23°C. The viscosity can be measured, for example, using an E type viscometer ("RE-80U" manufactured by Toki Sangyo Co., Ltd., 3° × R9.7 rotor) under the measurement conditions with a measurement sample amount of 0.22 ml and a number of revolutions of 5 rpm.

### Resin Sheet

The resin sheet of the present invention includes a support and a resin composition layer provided on the support. The resin composition layer contains the resin composition described above and preferably contains only the resin composition.

The thickness of the resin composition layer is preferably 250 µm or less, and more preferably 200 µm or less from the viewpoint of thinning. The lower limit of the thickness of the resin composition layer may be, for example, 5 µm or more or 10 µm or more.

Examples of the support include films of plastic materials, metallic foils, and release papers, and films formed of plastic materials and metallic foils are preferred.

When a film of a plastic material is used as the support, examples of the plastic material include polyesters such as polyethylene terephthalate (hereinafter may be abbreviated as "PET"), polyethylene naphthalate (hereinafter may be abbreviated as "PEN"), polycarbonate (hereinafter may be abbreviated as "PC"), acrylic polymers such as polymethyl methacrylate (PMMA), cyclic polyolefins, triacetyl cellulose (TAC), polyether sulfide (PES), polyether ketone, and polyimides. Among them, polyethylene terephthalate and polyethylene naphthalate are preferred, and polyethylene terephthalate, which is less expensive, is particularly preferred.

When a metal foil is used as the support, examples of the metal foil include copper foils and aluminum foils, and copper foils are preferred. As the copper foils, foils formed of copper single metal may be used or foils formed of alloys of copper and other metals (for example, tin, chromium, silver, magnesium, nickel, zirconium, silicon, and titanium) may be used.

The support may be matte treated or corona treated on its face to be bonded to the resin composition layer.

As the support, a releasing layer-attached support having a releasing layer on the surface to be bonded with the resin composition layer may be used. Examples of the releasing agent for use in the releasing layer of the support with a releasing layer include one or more releasing agents selected from the group consisting of alkyd type releasing agents, polyolefin type releasing agents, urethane type releasing agents, and silicone type releasing agents. As to the support with a releasing layer, commercially available products may be used, and examples thereof include "PET501010," "SK-1," "AL-5," and "AL-7" manufactured by Lintec Corporation; "Lumirror T60" manufactured by Toray Industries, Inc.; "Peulex" manufactured by Teijin Ltd.; and "Unipeel" manufactured by Unitika, Ltd., which are PET films having a release layer with a silicone type releasing agent or an alkyd resin type releasing agent as a main component.

The thickness of the support, which is not limited to a particular thickness, is preferably in a range of 5 µm to 75 µm and more preferably in a range of 10 µm to 60 um. When the support with a releasing layer is used, the thickness of the entire support with a releasing layer is preferably in the above range.

In the resin sheet, the face of the resin composition layer not bonded to the support (that is, the face opposite the support) may be provided with a protective film equivalent to the support. The thickness of the protective film, which is not limited to a particular thickness, is 1 µm to 40 um, for example. By providing the protective film, adhesion of dust and the like to the surface of the resin composition layer and scratches thereon can be inhibited.

The resin sheet can be produced by, for example, applying the resin composition onto the support using a die coater or the like to form the resin composition layer. If necessary, an organic solvent may be mixed into the resin composition before being applied onto the support. When the organic solvent is used, drying may be performed after the application if necessary.

The drying may be performed by, for example, a method such as heating or hot air blowing. The drying conditions are not limited to particular conditions, and the drying is performed such that the content of the organic solvent in the resin composition layer becomes 10% by mass or less, and preferably 5% by mass or less. The resin composition layer can be formed by drying at 50°C to 150°C for 3 minutes to 10 minutes, which vary depending on the components contained in the resin composition.

The resin sheet can be wound in roll form and stored. When having the protective film, the resin sheet can normally be used by peeling off the protective film.

### Circuit Board and Production Method Thereof

The circuit board includes the cured product of the resin composition described above. There is no restriction in the specific structure of the circuit board so far as the cured product of the resin composition is included therein. The circuit board according to a first example includes a substrate having a hole and a cured product of the resin composition that is filled in the hole. The circuit board according to a second example has a cured product layer that contains the cured product of the resin composition. Hereinafter, the production methods of the circuit boards according to the first example and the second example will be described. However, the circuit boards and the production methods thereof are not limited to the first example and the second example to be described below.

### Circuit Board according to the First Example

The circuit board according to the first example includes a substrate formed with a hole and a cured product of the resin composition filled in the hole. This circuit board can be produced, for example, by a production method that includes:
(1) a step of filling a hole in the substrate with the resin composition, and
(2) a step of thermally curing the resin composition to obtain the cured product. The production method of the circuit board according to the first example may further include
(3) a step of polishing a surface of the cured product or of the resin composition,
(4) a step of conducting a roughening treatment to the cured product, and
(5) a step of forming a conductor layer on the cured product. Usually, the steps (1) through (5) may be carried out sequentially in the order of the step (1), the step (2), the step (3), the step (4), and the step (5). The step (2) may be carried out after the step (3). In the production method of the circuit board according to the first example, it is preferable to form the cured product by using the resin composition in the form of a paste. In the explanation below, the example will be described in which a substrate formed with a through hole as the hole that goes through the substrate in the thickness direction is used.

### Step (1)

The step (1) usually includes a step of preparing a substrate formed with a through hole. The substrate may be prepared by purchasing from the market. Alternatively, the substrate may be prepared by producing it using a suitable material. Hereinafter, the production method of the substrate according to one example will be described.

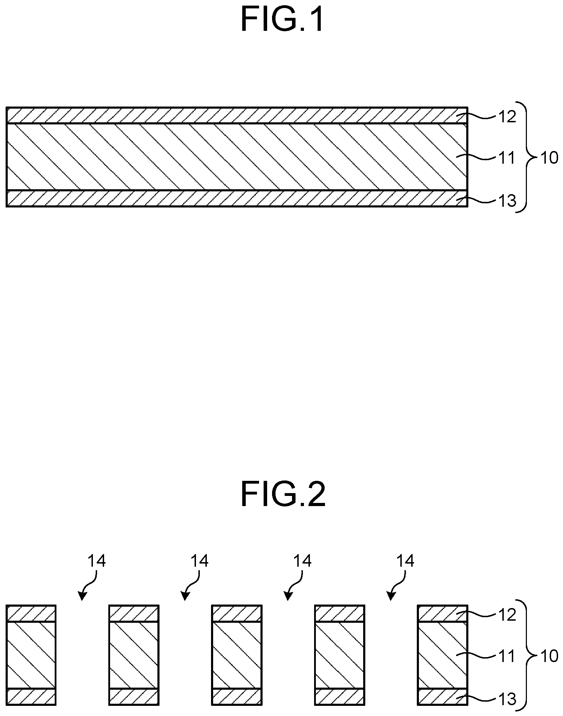

FIG. 1 is a schematic cross sectional view illustrating a core substrate 10 that is prepared in the production method of the circuit board according to the first example of one embodiment of the present invention. The step of preparing the substrate may include a step of preparing the core substrate 10, as illustrated in FIG. 1. The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both surfaces of the substrate. Here, the example is illustrated in which a metal layer 12 and a metal layer 13 are formed on both the surfaces of the supporting substrate 11. The metal layers 12 and 13 each may be, for example, a layer formed of a metal such as copper. The metal layers 12 and 13 may be, for example, copper foil such as carrier-attached copper foil, or a metal layer formed of a material of the conductor layer to be described later.

FIG. 2 is a schematic cross sectional view illustrating the core substrate 10 formed with a through hole 14 in the production method of the circuit board according to the first example of one embodiment of the present invention. The step of preparing the substrate may include a step of forming the through hole 14 in the core substrate 10, as an example illustrated in FIG. 2. The through hole 14 can be formed, for example, by drilling, laser irradiation, or plasma irradiation. Usually, the through hole 14 can be formed by forming a penetrating hole that goes through the core substrate 10. In a specific example, formation of the through hole 14 can be performed by using a drilling machine that is commercially available. Illustrative examples of the commercially available drilling machine may include "ND-1S211" manufactured by Hitachi Via Mechanics, Ltd.

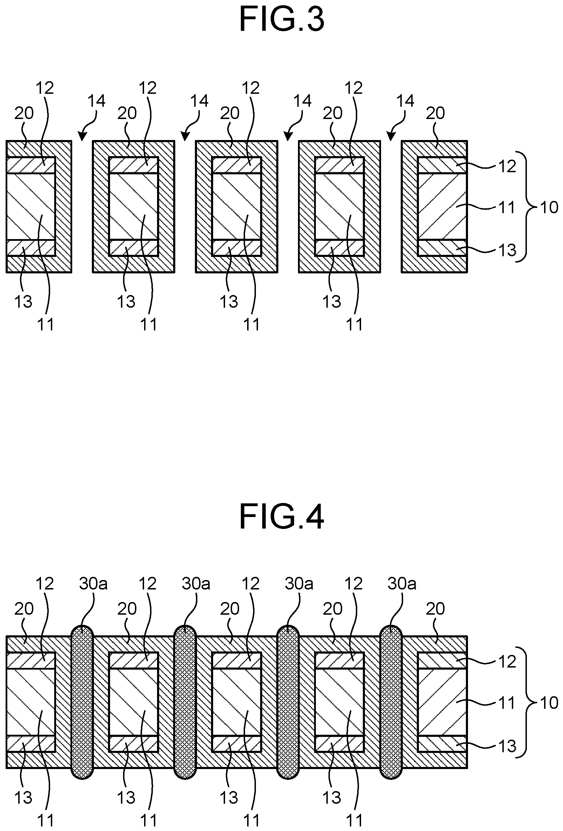

FIG. 3 is a schematic cross sectional view illustrating the core substrate 10 formed with a plated layer 20 in the through hole 14 in the production method of the circuit board according to the first example of one embodiment of the present invention. The step of preparing the substrate may include, after the core substrate 10 is subjected to the roughening treatment as needed, a step of forming the plated layer 20 as illustrated in FIG. 3. The roughening treatment may be performed with any of a dry roughening treatment and a wet roughening treatment. Illustrative examples of the dry roughening treatment may include a plasma treatment. Illustrative examples of the wet roughening treatment may include a method in which a swelling treatment by a swelling liquid, a roughening treatment by an oxidant, and a neutralizing treatment by a neutralizing solution are performed in this order. The plated layer 20 may be formed by a plating method. The procedure to form the plated layer 20 by the plating method may be the same as the procedure in formation of the conductor layer at the step (5) to be described later. Here, the explanation will be made as to the example in which the plated layer 20 is formed inside the through hole 14, on the surface of the metal layer 12, and on the surface of the metal layer 13.

FIG. 4 is a schematic cross sectional view illustrating the state of filling the through hole of the core substrate 10 with a resin composition 30a in the production method of the circuit board according to the first example of one embodiment of the present invention. The step (1) includes, after the core substrate 10 formed with the through hole 14 is prepared, filling the through hole 14 in the core substrate 10 with the resin composition 30a, as illustrated in FIG. 4. The filling may be performed, for example, by a printing method. Illustrative examples of the printing method may include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### Step (2)

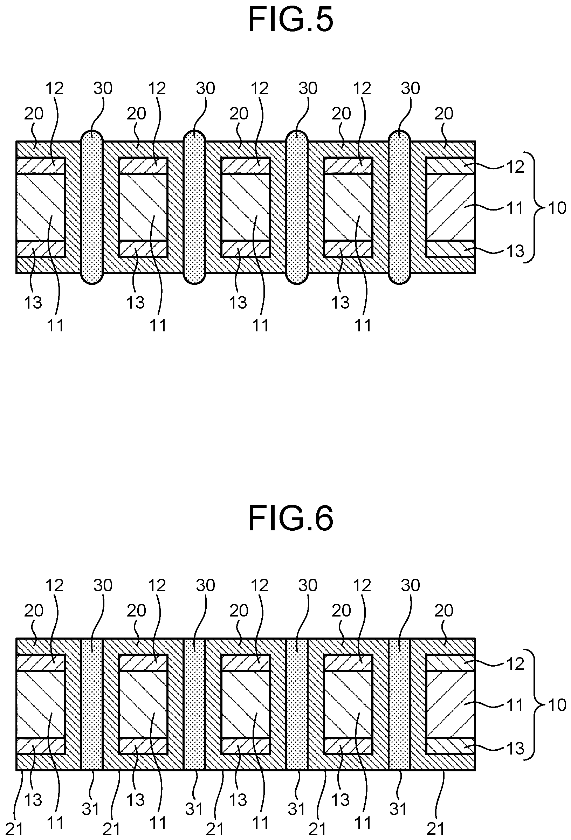

FIG. 5 is a schematic cross sectional view to explain the step (2) in the production method of the circuit board according to the first example of one embodiment of the present invention. The step (2) includes, after filling the through hole 14 with the resin composition 30a, curing the resin composition 30a to form a cured product 30, as illustrated in FIG. 5.

Curing of the resin composition 30a is usually performed by a thermal curing. The condition of the thermal curing of the resin composition 30a may be set as appropriate so far as curing of the resin composition 30a is proceeded. The curing temperature is preferably 120°C or higher, more preferably 130°C or higher, and even more preferably 150°C or higher, and is preferably 245°C or lower, more preferably 220°C or lower, and even more preferably 200°C or lower. The curing time is preferably 5 minutes or longer, more preferably 10 minutes or longer, and even more preferably 15 minutes or longer, and is preferably 120 minutes or shorter, more preferably 110 minutes or shorter, and even more preferably 100 minutes or shorter.

The curing degree of the cured product 30 that is obtained at the step (2) is preferably 80% or more, more preferably 85% or more, and even more preferably 90% or more. The curing degree can be measured by using, for example, a differential scanning calorimeter.

The production method of the circuit board according to the first example may include, after filling the through hole 14 with the resin composition 30a and before curing the resin composition 30a, a step of heating the resin composition 30a at a temperature lower than the curing temperature (preliminary heating step). For example, prior to curing the resin composition 30a, the resin composition 30a may be preliminarily heated at a temperature of usually 50°C or higher and lower than 120°C (preferably 60°C or higher and 110°C or lower, more preferably 70°C or higher and 100°C or lower), usually for 5 minutes or longer (preferably for 5 minutes to 150 minutes, more preferably for 15 minutes to 120 minutes).

### Step (3)

FIG. 6 is a schematic cross sectional view to explain the step (3) in the production method of the circuit board according to the first example of one embodiment of the present invention. When the through-hole 14 is filled with the resin composition 30a in the step (1), an excess of the resin composition 30a may protrude to or adhere with the outside the through-hole 14. Therefore, the resin composition 30a may be present not only inside the through hole 14 but also outside the through hole 14. The step (3) includes polishing the excess of the cured product 30 protruding from or adhering to the core substrate 10, as illustrated in FIG. 6. The excess of the cured product 30 is removed by polishing, so that the surface of the cured product 30 can be flattened. A surface (polished surface) 31 of the cured product 30 that had been flattened by polishing may usually form a plane that is flush with a surrounding surface 21 of the polished surface 31 (e.g., the surface of the core substrate 10 and the surface of the plated layer 20).

As for the polishing method of the cured product 30, the method with which the excess of the cured product 30 protruding from or adhering to the core substrate 10 can be removed may be used. Illustrative examples of the polishing method as described above may include a buff polishing method, a belt polishing method, and a ceramic polishing method. Illustrative examples of the buff polishing equipment that is commercially available may include "NT-700IM" manufactured by Ishiihyoki Co., Ltd.

From the viewpoint of enhancing the adhesion with the conductor layer, the arithmetic average roughness (Ra) of the polished surface (surface after curing) 31 of the cured product 30 is preferably 300 nm or more, more preferably 350 nm or more, and even more preferably 400 nm or more. The upper limit thereof is preferably 1000 nm or less, more preferably 900 nm or less, and even more preferably 800 nm or less. The surface roughness (Ra) can be measured, for example, by using a non-contact type surface roughness meter.

The production method of the circuit board according to the first example may include, after the step (3), a step of subjecting the cured product 30 to a heat-treatment in order to further increase the curing degree of the cured product 30. As for the temperature at this heat treatment, the aforementioned curing temperature may be applied. Specifically, the heat treatment temperature is preferably 120°C or higher, more preferably 130°C or higher, and even more preferably 150°C or higher, and is preferably 245°C or lower, more preferably 220°C or lower, and even more preferably 200°C or lower. The heat treatment period is preferably 5 minutes or longer, more preferably 10 minutes or longer, and even more preferably 15 minutes or longer, and is preferably 90 minutes or shorter, more preferably 70 minutes or shorter, and evenmore preferably 60 minutes or shorter.

In the case where the step (3) is carried out before the step (2), a preliminary heating treatment may be carried out to heat the resin composition at a temperature lower than the curing temperature of the resin composition before the step (3). The temperature at the preliminary heating treatment is preferably 100°C or higher, more preferably 110°C or higher, and even more preferably 120°C or higher, and is preferably 245°C or lower, more preferably 220°C or lower, and even more preferably 200°C or lower. The heat treatment period is preferably 5 minutes or longer, more preferably 10 minutes or longer, and even more preferably 15 minutes or longer, and is preferably 90 minutes or shorter, more preferably 70 minutes or shorter, and even more preferably 60 minutes or shorter.

### Step (4)

The step (4) includes subjecting the cured product 30 to the roughening treatment (desmear treatment). With the roughening treatment, the surface of the cured product 30 is roughened. When the surface of the cured product 30 has been polished, this step usually includes subjecting the polished surface 31 to the roughening treatment (desmear treatment). There is no particular restriction in the procedure and condition of the roughening treatment; for example, the procedure and condition that are used in the production method of a multilayer printed wiring board may be used. In a specific example, the roughening treatment to the cured product 30 may be performed by conducting the method including a swelling treatment with a swelling liquid, a roughening treatment with an oxidant, and a neutralizing treatment with a neutralizing solution in this order.

Illustrative examples of the swelling liquid that may be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid can be carried out, for example, by immersing the cured product 30 into the swelling liquid at the temperature of 30°C to 90°C for the period of 1 minute to 20 minutes. From the viewpoint of suppressing the swelling of the resin included in the cured product 30 to a suitable level, it is preferable that the cured product 30 is immersed into the swelling liquid at the temperature of 40°C to 80°C for the period of 5 minutes to 15 minutes.

Illustrative examples of the oxidant that may be used in the roughening treatment with the oxidant may include an alkaline permanganate solution having potassium permanganate or sodium permanganate dissolved into a sodium hydroxide aqueous solution. The roughening treatment using the oxidant such as the alkaline permanganate solution is preferably carried out by immersing the cured product 30 into the oxidant solution heated at 60°C to 80°C for the period of 10 minutes to 30 minutes. The concentration of the permanganate salt in the alkaline permanganate solution is preferably in the range of 5% by mass to 10% by mass. Illustrative examples of the oxidant that is commercially available may include alkaline permanganate solutions such as "Concentrate Compact P" and "Dosing Solution Securiganth P", both of which are manufactured by Atotech Japan, Co., Ltd.

The neutralizing solution that may be used in the neutralizing treatment is preferably an acidic aqueous solution. A commercially available neutralizing solution is, for example, "Reduction Solution Securigance P" manufactured by Atotech Japan Co., Ltd. The neutralizing treatment with the neutralizing solution can be carried out by immersing the treated surface, which has been subjected to the roughening treatment using the oxidant solution, into the neutralizing solution in the temperature range of 30°C to 80°C for the period of 5 minutes to 30 minutes. From the viewpoint of workability, it is preferable to immerse the cured product 30, which has been subjected to the roughening treatment using the oxidant solution, into the neutralizing solution in the temperature range of 40°C to 70°C for the period of 5 minutes to 20 minutes.

From a viewpoint of improving the adhesion with a conductor layer, the arithmetic average roughness (Ra) of the surface of the cured product 30 after the roughening treatment is preferably 300 nm or more, more preferably 350 nm or more, and even more preferably 400 nm or more. The upper limit thereof is preferably 1500 nm or less, more preferably 1200 nm or less, and even more preferably 1000 nm or less. The surface roughness (Ra) can be measured, for example, by using a non-contact type surface roughness meter.

### Step (5)

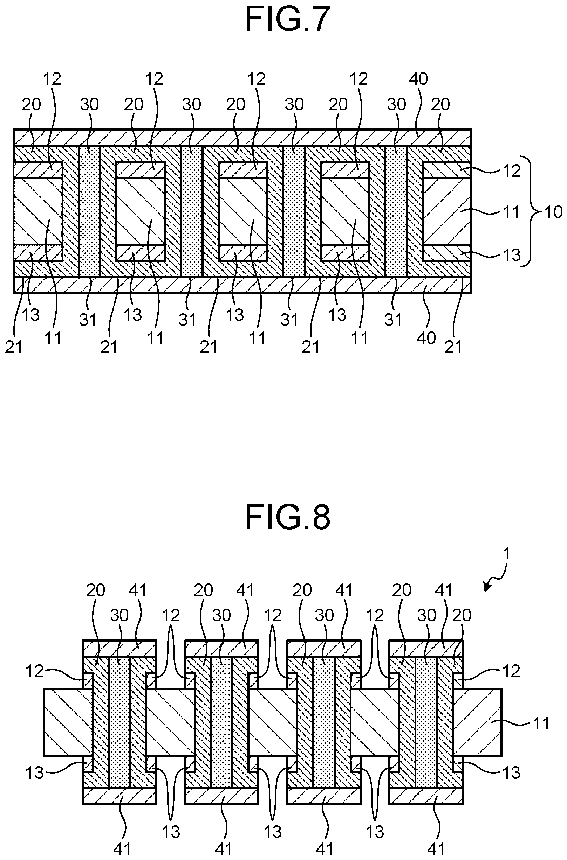

FIG. 7 is a schematic cross sectional view to explain the step (5) in the production method of the circuit board according to the first example of one embodiment of the present invention. The step (5) includes forming a conductor layer 40 on the polished surface 31 of the cured product 30, as illustrated in FIG. 7. Here, the example is illustrated in which the conductor layer 40 is formed not only on the polished surface 31 of the cured product 30 but also on the surrounding surface 21 (for example, the surface of the core substrate 10 and the surface of the plated layer 20). In FIG. 7, the example that the conductor layer 40 is formed on both sides of the core substrate 10 is illustrated; but the conductor layer 40 may be formed on only one side of the core substrate 10.

FIG. 8 is a schematic cross sectional view to explain the step (5) in the production method of the circuit board according to the first example of one embodiment of the present invention. As illustrated in FIG. 8, after the conductor layer 40 is formed, the step (5) may include removing a part of the conductor layer 40, the metal layer 12, the metal layer 13, and the plated layer 20 to form a patterned conductor layer 41 by a treatment such as etching.

Illustrative examples of the method for forming the conductor layer 40 may include a plating method, a sputtering method, and a vapor deposition method. Among these, a plating method is preferable. In a preferable embodiment, the surface of the cured product 30 (and the plated layer 20) is plated with a suitable method such as a semi-additive method or a full additive method, so that the patterned conductor layer 41 having an intended wiring pattern may be formed. Illustrative examples of the material of the conductor layer 40 may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is even more preferably used.

Here, the example of the method for forming the patterned conductor layer 41 on the polished surface 31 of the cured product 30 will be explained in detail. A plating seed layer is formed on the polished surface 31 of the cured product 30 by an electroless plating. Next, on the resulting plating seed layer, an electroplated layer is formed by an electroplating. Then, as needed, an unnecessary plating seed layer is removed by a treatment such as etching, so that the patterned conductor layer 41 having an intended wiring pattern can be formed. After the patterned conductor layer 41 is formed, in order to improve the adhesion strength of the patterned conductor layer 41, an annealing treatment may be performed as needed. The annealing treatment can be performed, for example, by heating in the temperature range of 150°C to 200°C for the period of 20 minutes to 90 minutes.

From the viewpoint of thinning, the thickness of the patterned conductor layer 41 is preferably 70 µm or less, more preferably 60 µm or less, even more preferably 50 µm or less, even even more preferably 40 µm or less, and especially preferably 30 µm or less, 20 µm or less, 15 um or less, or 10 µm or less. The lower limit thereof is preferably 1 µm or more, more preferably 3 µm or more, and even more preferably 5 µm or more.

By the method described above, a circuit board 1 including the cured product 30 of the resin composition 30a can be produced.

### Circuit Board according to Second Example

The circuit board according to a second example includes a cured product layer including the cured product of the resin composition. Preferably, the cured product layer includes only the cured product of the resin composition. It is preferable that the cured product layer is formed by using a resin sheet. This circuit board can be produced, for example, by a production method that includes:
(i) a step of forming a cured product layer on an inner layer substrate,
(ii) a step of forming a hole in the cured product layer,
(iii) a step of roughening a surface of the cured product layer, and
(iv) a step of forming a conductor layer on the surface of the cured product layer.

### Step (i)

The step (i) includes forming a cured product layer on the inner layer substrate. Preferably, the step (i) includes laminating the resin sheet onto the inner layer substrate in such a way that the resin composition layer is adhered with the inner layer substrate and forming the cured product layer. For example, the resin sheet is laminated to the inner layer substrate in such a way that the resin composition layer is adhered with the inner layer substrate, and then, the resin composition layer is thermally cured to form the cured product layer.

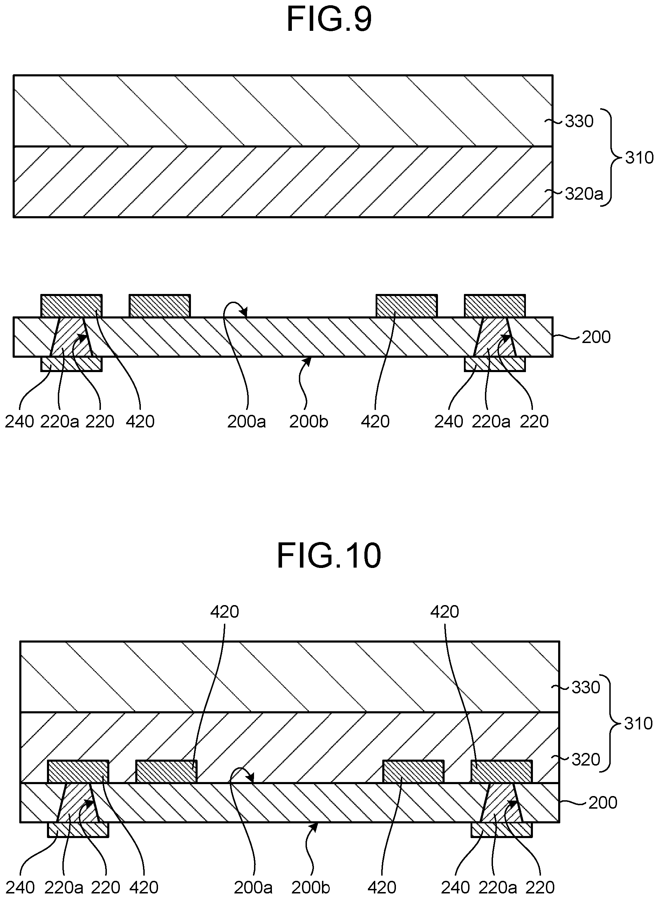

FIG. 9 is a schematic cross sectional view to explain the step (i) in the production method of the circuit board according to the second example of one embodiment of the present invention. As illustrated in FIG. 9, a resin sheet 310 including a support 330 and a resin composition layer 320a formed on the support 330 is prepared. Then, the resin sheet 310 and an inner layer substrate 200 are laminated such that the resin composition layer 320a is adhered with the inner layer substrate 200.

An insulating substrate may be used as the inner layer substrate 200. Illustrative examples of the inner layer substrate 200 may include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit board having a wiring or the like incorporated in the thickness thereof.

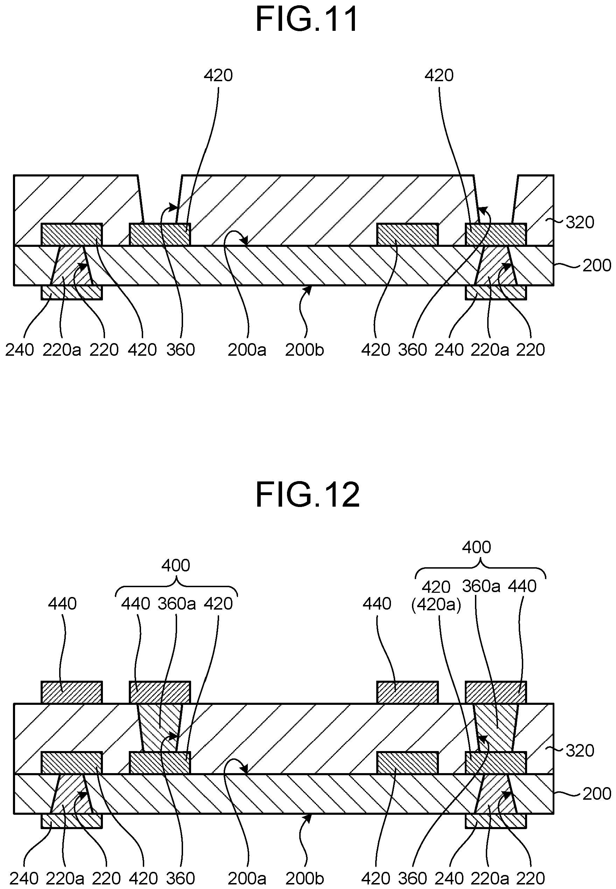

The inner layer substrate 200 illustrated in this example included a first conductor layer 420 formed on a first main surface 200a and an external terminal 240 formed on a second main surface 200b. The first conductor layer 420 may include a plurality of wires. Note that, in the example illustrated in FIG. 9, only the wiring that constitutes a coil-shaped conductive structural body 400 (see FIG. 12) of an inductor element is illustrated. The external terminal 240 may be a terminal for electrical connection to an external device or the like that is not illustrated in the drawing. The external terminal 240 can be configured as part of a conductor layer formed on the second main surface 200b.

The conductor material that can constitute the first conductor layer 420 and the external terminal 240 may be, for example, the same as the material of the conductor layer described in the first example.

The first conductor layer 420 and the external terminal 240 may have any of a monolayer structure and a multi-layer structure in which two or more layers formed of single-metal layers or alloy layers formed of different metals or alloys are laminated. The thicknesses of the first conductor layer 420 and of the external terminal 240 may be the same as that of a second conductor layer 440 to be described later.

The line and space (L/S) of the first conductor layer 420 and of the external terminal 240 is not particularly restricted. From the viewpoint of reducing a surface irregularity thereby obtaining the cured product layer having an excellent smoothness, the ratio is usually 900 µm/900 µm or less, preferably 700 µm/700 µm or less, more preferably 500 µm/500 µm or less, even more preferably 300 µm/300 µm or less, and further even more preferably 200 µm/200 µm or less. There is no particular restriction in the lower limit of the line and space (L/S); but from the viewpoint of enhancing an embedding property of the resin composition layer into the space, the lower limit is preferably 1 µm/1 µm or more.

The inner layer substrate 200 may have a plurality of through holes 220 that go through the inner layer substrate 200 from the first main surface 200a to the second main surface 200b. In the through hole 220, an inside-the-through-hole wiring 220a is formed. The inside-the-through-hole wiring 220a electrically connects the first conductor layer 420 with the external terminal 240.

Adhesion of the resin composition layer 320a with the inner layer substrate 200 can be performed, for example, by hot-pressing of the resin sheet 310 to the inner layer substrate 200 by pressing from the side of the support 330. Illustrative examples of the member (hereinafter, this member may be referred to as "hot-pressing member") used for the hot-pressing of the resin sheet 310 to the inner layer substrate 200 may include a heated metal plate (e.g., stainless steel (SUS) mirror plate) and a metal roll (SUS roll). Here, it is preferable that the hot-pressing member is not pressed in direct contact with the resin sheet 310 but is pressed via an sheet or the like formed of an elastic material such as a heat-resistant rubber in such a way that the resin sheet 310 can well follow the irregularity on the surface of the inner layer substrate 200.

The temperature at the time of the hot-pressing is preferably 80°C to 160°C, more preferably 90°C to 140°C, and even more preferably 100°C and 120°C. The pressure at the time of the hot-pressing is preferably 0.098 MPa to 1.77 MPa, and more preferably 0.29 MPa to 1.47 MPa. The period at the time of the hot-pressing is preferably 20 seconds to 400 seconds, and more preferably 30 seconds to 300 seconds. It is preferable that the adhesion of the resin sheet with the inner layer substrate is performed under the condition of a reduced pressure of 26.7 hPa or less.

Adhesion of the resin composition layer 320a of the resin sheet 310 with the inner layer substrate 200 can be performed by using a commercially available vacuum laminator. Illustrative examples of the commercially available vacuum laminator may include a vacuum pressing laminator manufactured by Meiki Co., Ltd. and a vacuum applicator manufactured by Nikko-Materials Co., Ltd.

After adhesion of the resin sheet 310 with the inner layer substrate 200, the resin sheet 310 thereby laminated may be subjected to, for example, a flattening treatment by pressing the hot-pressing member from the side of the support 330 under a normal pressure (under an atmospheric pressure). The pressing conditions in the flattening treatment may be the same as the hot-pressing conditions in the aforementioned lamination. The flattening treatment can be performed by a commercially available laminator. The lamination and the flattening treatments may be carried out continuously by using the commercially available vacuum laminator described before.

FIG. 10 is a schematic cross sectional view to explain the step (i) in the production method of the circuit board according to the second example of one embodiment of the present invention. After the resin sheet 310 is laminated onto the inner layer substrate 200, the resin composition layer 320a is cured to form the cured product layer. In this example, as illustrated in FIG. 10, the resin composition layer 320a that has been adhered with the inner layer substrate 200 is thermally cured to form a first cured product layer 320.

Conditions of the thermal curing of the resin composition layer 320a may be set as appropriate so far as curing of the resin composition can be proceeded. The curing temperature is preferably 120°C or higher, more preferably 130°C or higher, and even more preferably 150°C or higher, and is preferably 245°C or lower, more preferably 220°C or lower, and even more preferably 200°C or lower. The curing time is preferably 5 minutes or longer, more preferably 10 minutes or longer, and even more preferably 15 minutes or longer, and is preferably 120 minutes or shorter, more preferably 110 minutes or shorter, and even more preferably 100 minutes or shorter.

The support 330 may be removed between after the thermal curing at the step (i) and the step (ii), or it may be removed after the step (ii).

From the viewpoint of enhancing the adhesion with the plating, the arithmetic average roughness (Ra) of the cured product layer before the roughening treatment is preferably 300 nm or more, more preferably 350 nm or more, and even more preferably 400 nm or more. The upper limit thereof is preferably 1000 nm or less, more preferably 900 nm or less, and even more preferably 800 nm or less. The surface roughness (Ra) can be measured, for example, by using a non-contact type surface roughness meter.

At the step (i), instead of the resin sheet, the resin composition may be applied onto the inner layer substrate 200 using a die coater or the like followed by the thermal cure to form the cured product layer.

### Step (ii)

FIG. 11 is a schematic cross sectional view to explain the step (ii) in the production method of the circuit board according to the second example of one embodiment of the present invention. The step (ii) includes forming a hole in the first cured product layer 320 to form a via hole 360, as illustrated in FIG. 11. The via hole 360 forms a channel for electrically connecting the first conductor layer 420 and the second conductor layer 440 to be described later. Formation of the via hole 360 may be performed using, for example, drilling, a laser, or a plasma. The size and shape of the hole may be determined as appropriate in accordance with the design of the printed wiring board.

### Step (iii)

At the step (iii), the surface of the cured product layer in which the via hole is formed is subjected to a roughening treatment. The roughening treatment at the step (iii) may be performed in the same way as described at the step (4) of the first example.

From the viewpoint of improving the adhesion with the plating, the arithmetic average roughness (Ra) of the cured product layer after the roughening treatment is preferably 300 nm or more, more preferably 350 nm or more, and even more preferably 400 nm or more. The upper limit thereof is preferably 1500 nm or less, more preferably 1200 nm or less, and even more preferably 1000 nm or less. The surface roughness (Ra) can be measured, for example, by using a non-contact type surface roughness meter.

### Step (iv)

FIG. 12 is a schematic cross sectional view to explain the step (iv) in the production method of the circuit board according to the second example of one embodiment of the present invention. As illustrated in FIG. 12, at the step (iv), the second conductor layer 440 is formed on the first cured product layer 320.

The conductor material that can constitute the second conductor layer 440 may be, for example, the same as the material of the conductor layer described in the first example.

From the viewpoint of thinning, the thickness of the second conductor layer 440 is preferably 70 µm or less, more preferably 60 µm or less, even more preferably 50 µm or less, even even more preferably 40 µm or less, and especially preferably 30 µm or less, 20 µm or less, 15 um or less, or 10 µm or less. The lower limit thereof is preferably 1 µm or more, more preferably 3 µm or more, and even more preferably 5 µm or more.

The second conductor layer 440 can be formed by plating. For example, the second conductor layer 440 is preferably formed by wet plating methods such as a semi-additive method that includes an electroless plating step, a mask patterning step, an electrolytic plating step, and a flash etching step, and a full-additive method. By forming the second conductor layer 440 by the wet plating method, the second conductor layer 440 having an intended wiring pattern can be formed. At this step, an inside-the-via-hole wiring 360a is also formed in the via hole 360.

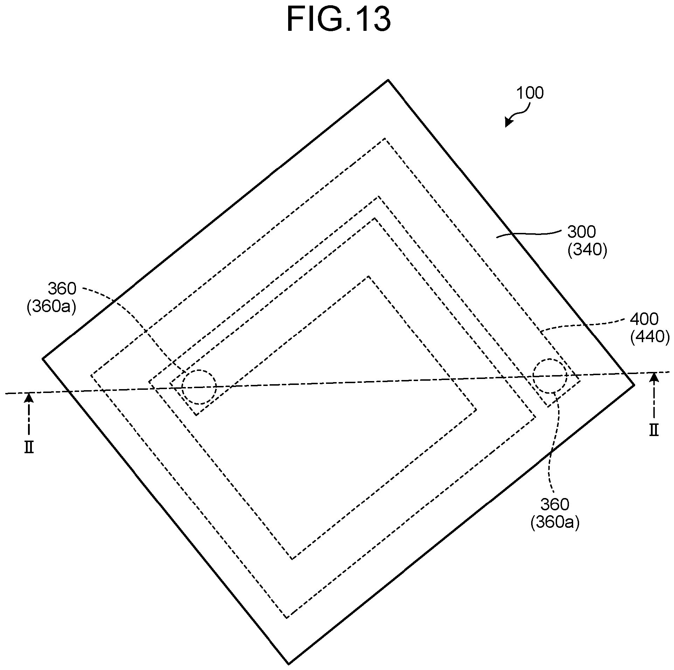

The first conductor layer 420 and the second conductor layer 440 may be formed in a spiral form, for example, as illustrated in FIGs. 13 to 15 to be described later as one example. In one example, one end of the central side of the spiral wiring portion of the second conductor layer 440 is electrically connected thorough the inside-the-via-hole wiring 360a to one end of the central side of the spiral wiring portion of the first conductor layer 420. The other end of the outer circumferential side of the spiral wiring portion of the second conductor layer 440 is electrically connected through the inside-the-via-hole wiring 360a to a land 420a of the first conductor layer 420. Therefore, the other end of the outer circumferential side of the spiral wiring portion of the second conductor layer 440 is electrically connected to the external terminal 240 via the inside-the-via-hole wiring 360a, the land 420a, and the inside-the-through-hole wiring 220a.

The coil-shaped conductive structural body 400 is composed of a spiral wiring portion that is a portion of the first conductor layer 420, a spiral wiring portion that is a portion of the second conductor layer 440, and the inside-the-via-hole wiring 360a that electrically connects the spiral wiring portion of the first conductor layer 420 with the spiral wiring portion of the second conductor layer 440.

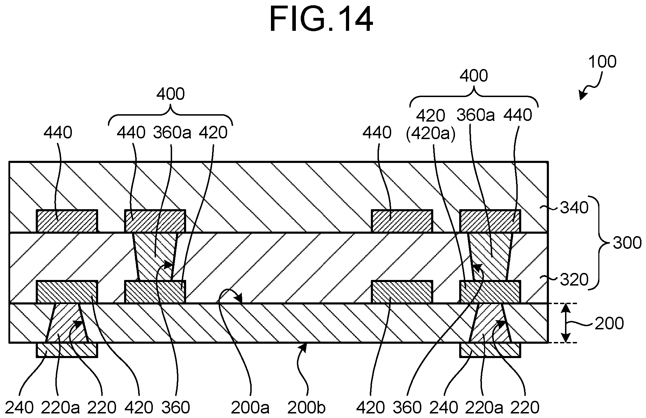

After the step (iv), a step of further forming the cured product layer on the conductor layer may be carried out. As illustrated in detail in FIG. 14 as one example, the second cured product layer 340 is formed on the second conductor layer 440 and the first cured product layer 320 in which the inside-the-via-hole wiring 360a is formed. The second cured product layer may be formed with the same step as the step that has already been described. By the method described above, a circuit board 100 including the first cured product layer 320 and the second cured product layer 340 formed of the cured product of the resin composition may can produced.

### Inductor Substrate

The inductor substrate includes the circuit board described above. When the inductor substrate includes the circuit board obtained by the production method of the circuit board according to the first example described above, the inductor substrate may have an inductor pattern formed by a conductor at least partially around the cured product of the resin composition. In this case, the inductor substrate may include an inductor element that is composed of an inductor pattern which is formed, for example, by at least a part of the metal layer 12, the metal layer 13, the plated layer 20, and the patterned conductor layer 41, and a core portion formed of the cured product 30 surrounded by the inductor pattern. As for the inductor substrate, the one that is described in Japanese Patent Application Laid-open No. 2016-197624 may be used, for example.

When the inductor substrate includes the circuit board obtained by the production method of the circuit board according to the second example, the inductor substrate may have the cured product layer and the conductive structural body having at least part thereof embedded in the cured product layer. The inductor substrate may include the inductor element composed of the conductive structural body and a part of the cured product layer that extends in the thickness direction of the cured product layer and is surrounded by the conductive structural body.

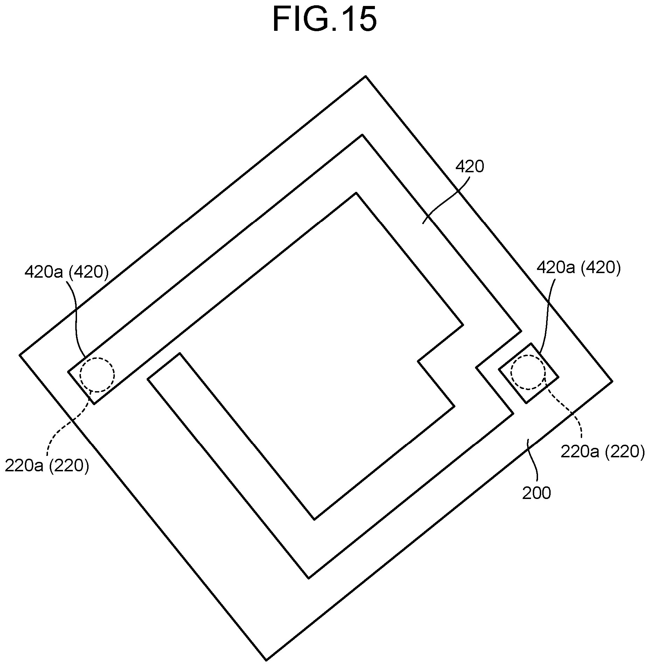

FIG. 13 is a schematic plan view of the circuit board 100 possessed by the inductor substrate, observed from one side in the thickness directions thereof. FIG. 14 is a schematic view illustrating the cut end face of the circuit board 100 cut at the position indicated by the II-II single-dotted line in FIG. 13. FIG. 15 is a schematic plan view to explain the composition of the first conductor layer 420 of the circuit board 100 included in the inductor substrate.

The circuit board 100 may be a substrate having a plurality of the cured product layers (the first cured product layer 320 and the second cured product layer 340) and a plurality of the conductor layers (the first conductor layer 420 and the second conductor layer 440), as illustrated in FIG. 13 and FIG. 14 as one example. Thus, in the example illustrated here, the circuit board 100 may be a build-up wiring board having a build-up cured product layer and a build-up conductor layer. The circuit board 100 has an inner layer substrate 200.

As illustrated in FIG. 14, the first cured product layer 320 and the second cured product layer 340 constitute the magnetic portion 300, which may be considered as an integral cured product layer. Therefore, the coil-shaped conductive structural body 400 is formed such that at least a part thereof is embedded in the magnetic portion 300. In other words, in the circuit board 100 illustrated in this example, the inductor element is composed of the coil-shaped conductive structural body 400 and the core portion, which is a part of the magnetic portion 300 that extends to the thickness direction of the magnetic portion 300 and is surrounded by the coil-shaped conductive structural body 400.

As illustrated in FIG. 15 as one example, the first conductor layer 420 includes a spiral wiring portion to constitute the coil-shaped conductive structural body 400 and the rectangular land 420a that is electrically connected to the inside-the-through-hole wiring 220a. In the example illustrated here, the spiral wiring portion includes straight portions, bending portions that bend at right angles, and a detour portion that detours the land 420a. The spiral wiring portion of the first conductor layer 420 has an overall outline of a substantially rectangular shape and has the shape that the wiring portion is whirled in a counterclockwise direction from the center side to the outer side thereof.

Similarly, the second conductor layer 440 is formed on the first cured product layer 320. The second conductor layer 440 includes the spiral wiring portion to form the coil-shaped conductive structural body 400. In FIG. 13 or FIG. 14, the spiral wiring portion includes the straight portions and the bending portions that bend at right angles. In Fig. 13 or Fig. 14, the spiral wiring portion of the second conductor layer 440 has an overall outline of a substantially rectangular shape and has the shape that the wiring portion is whirled in a clockwise direction from the center side to the outer side thereof.

The inductor substrate described above may be used as the wiring board to mount an electronic part such as a semiconductor chip, and may also be used as a (multilayered) printed wiring board that uses this wiring board as the inner layer substrate. In addition, the inductor substrate may be used as a chip inductor component obtained by dicing the wiring board, and may also be used as a printed wiring board that is surface-mounted with the chip inductor component.

By using this wiring board, semiconductor devices with various embodiments can be produced. The semiconductor device including the wiring board can be suitably used in electric products (for example, a computer, a mobile phone, a digital camera, and a television), vehicles (for example, a motor bike, an automobile, a train, a marine ship, and an airplane), and so forth.

### Examples

The following specifically describes the present invention with reference to examples. The present invention is not limited to these examples. In the following, "%" and "parts" representing amounts mean "% by mass" and "parts by mass" unless otherwise indicated. The temperature condition when no specific temperature is specified is room temperature (23°C). The pressure condition when no specific pressure is specified is ambient pressure (1 atm).

### Example 1: Preparation of Varnish-Like Resin Composition 1

Uniformly dispersed were 65.5 parts by mass of a Fe-Ni-Cr type alloy magnetic powder ("AKT-PB-2Cr" manufactured by Mitsubishi Steel Mfg. Co., Ltd., an alloy with Fe: 52.2%, Ni: 45.1%, Si: 0.7%, and Cr: 1.9%, average particle size (D₅₀) : 5 um, true density: 8.0 g/cm³), 19.6 parts by mass of a Mn-Zn type ferrite powder ("MZ03S_1" manufactured by Powdertech Co., Ltd., a Mn-Zn type ferrite powder with Fe: 48.2%, Mn: 16.5%, and Zn: 6.3%, average particle size (D₅₀) : 0.4 µm, true density: 5.1 g/cm³), 1.63 parts by mass of an epoxy resin ("ZX-1059" manufactured by NIPPON STEEL Chemical & Material Co., Ltd., a mixed product of a bisphenol A type epoxy resin and a bisphenol F type epoxy resin, epoxy equivalent: 169 g/eq., true density: 1.2 g/cm³), 1.85 parts by mass of a phenolic resin ("LA-7054" manufactured by DIC Corporation, an aminotriazine-modified phenol novolac resin, a MEK solution with a nonvolatile component of 60%, hydroxy group equivalent: 125 g/eq., the true density of the nonvolatile component: 1.2 g/cm³), 1.61 parts by mass of a phenoxy resin ("YX7553BH30" manufactured by Mitsubishi Chemical Corporation, a methyl ethyl ketone:cyclohexanone = 1:1 solution with a nonvolatile component of 30%, a special skeleton phenoxy resin, the true density of the nonvolatile component: 1.2 g/cm³), 0.70 part by mass of a dispersant ("PB-881" manufactured by Ajinomoto Fine-Techno Co., Inc., a polyester type dispersant, true density: 1.2 g/cm³), and 0.01 part by mass of a curing accelerator ("2E4MZ" manufactured by Shikoku Chemicals Corporation, an imidazole type curing accelerator, true density: 1.2 g/cm³) to prepare a varnish-like resin composition 1.

### Example 2: Preparation of Varnish-Like Resin Composition 2

In Example 1,
1) the amount of the Fe-Ni-Cr type alloy magnetic powder ("AKT-PB-2Cr" manufactured by Mitsubishi Steel Mfg. Co., Ltd.) was changed from 65.5 parts by mass to 56.4 parts by mass, and
2) the amount of the magnetic powder ("MZ03S_1" manufactured by Powdertech Co., Ltd.) was changed from 19.6 parts by mass to 25.0 parts by mass.

A varnish-like resin composition 2 was prepared in the same manner as in Example 1 except the above matter.

### Example 3: Preparation of Varnish-Like Resin Composition 3

In Example 1,
1) the amount of the Fe-Ni-Cr type alloy magnetic powder ("AKT-PB-2Cr" manufactured by Mitsubishi Steel Mfg. Co., Ltd.) was changed from 65.5 parts by mass to 52.7 parts by mass, and
2) the amount of the Mn-Zn type ferrite powder ("MZ03S_1" manufactured by Powdertech Co., Ltd.) was changed from 19.6 parts by mass to 27.9 parts by mass.

A varnish-like resin composition 3 was prepared in the same manner as in Example 1 except the above matter.

### Example 4: Preparation of Varnish-Like Resin Composition 4

In Example 2, 25.0 parts by mass of the Mn-Zn type ferrite powder ("MZ03S_1" manufactured by Powdertech Co., Ltd.) was changed to 25.0 parts by mass of a Mn type ferrite powder ("M03S_1" manufactured by Powdertech Co., Ltd., a Mn type ferrite powder with Fe: 44.2% and Mn: 25.1%, average particle size (D₅₀) : 0.4 um, true density: 5.1 g/cm³) .

A varnish-like resin composition 4 was prepared in the same manner as in Example 2 except the above matter.

### Example 5: Preparation of Varnish-Like Resin Composition 5

In Example 1, 19.6 parts by mass of the Mn-Zn type ferrite powder ("MZ03S_1" manufactured by Powdertech Co., Ltd.) was changed to 19.6 parts by mass of a Mn type ferrite powder ("M03S_3" manufactured by Powdertech Co., Ltd., a Fe-Mn type ferrite powder with Fe: 56.0% and Mn: 13.9%, average particle size (D₅₀) : 0.4 um, true density: 5.1 g/cm³).

A varnish-like resin composition 5 was prepared in the same manner as in Example 1 except the above matter.

### Example 6: Preparation of Varnish-Like Resin Composition 6

In Example 2, 25.0 parts by mass of the Mn-Zn type ferrite powder ("MZ03S_1" manufactured by Powdertech Co., Ltd.) was changed to 25.0 parts by mass of a Mn type ferrite powder ("M03S_3" manufactured by Powdertech Co., Ltd., a Mn type ferrite powder with Fe: 56.0% and Mn: 13.9%, average particle size (D₅₀) : 0.4 um, true density: 5.1 g/cm³) .

A varnish-like resin composition 6 was prepared in the same manner as in Example 2 except the above matter.

### Example 7: Preparation of Varnish-Like Resin Composition 7

In Example 1, 65.5 parts by mass of the Fe-Ni-Cr type alloy magnetic powder ("AKT-PB-2Cr" manufactured by Mitsubishi Steel Mfg. Co., Ltd.) was changed to 65.5 parts by mass of another Fe-Ni-Cr type alloy magnetic powder ("AKT-PB-1Cr" manufactured by Mitsubishi Steel Mfg. Co., Ltd., an alloy with Fe: 53.3%, Ni: 45.0%, Si: 0.7%, and Cr: 1.0%, average particle size (D₅₀): 5 um, true density: 8.0 g/cm³) .

A varnish-like resin composition 7 was prepared in the same manner as in Example 1 except the above matter.

### Example 8: Preparation of Varnish-Like Resin Composition 8

In Example 1, 65.5 parts by mass of the Fe-Ni-Cr type alloy magnetic powder ("AKT-PB-2Cr" manufactured by Mitsubishi Steel Mfg. Co., Ltd.) was changed to 65.5 parts by mass of another Fe-Ni-Cr type alloy magnetic powder ("AKT-PB-3Cr" manufactured by Mitsubishi Steel Mfg. Co., Ltd., an alloy with Fe: 51.0%, Ni: 45.1%, Si: 0.8%, and Cr: 3.1%, average particle size (D₅₀) : 5 um, true density: 8.0 g/cm³) .

A varnish-like resin composition 8 was prepared in the same manner as in Example 1 except the above matter.

### Example 9: Preparation of Varnish-Like Resin Composition 9

In Example 1, 65.5 parts by mass of the Fe-Ni-Cr type alloy magnetic powder ("AKT-PB-2Cr" manufactured by Mitsubishi Steel Mfg. Co., Ltd.) was changed to 65.5 parts by mass of another Fe-Ni-Cr type alloy magnetic powder ("AKT-PB-4Cr" manufactured by Mitsubishi Steel Mfg. Co., Ltd., an alloy with Fe: 49.4%, Ni: 45.9%, Si: 0.8%, and Cr: 3.9%, average particle size (D₅₀) : 5 um, true density: 8.0 g/cm³) .

A varnish-like resin composition 9 was prepared in the same manner as in Example 1 except the above matter.

### Comparative Example 1: Preparation of Varnish-Like Resin Composition 10

In Example 2, 25.0 parts by mass of the Mn-Zn type ferrite powder ("MZ03S_1" manufactured by Powdertech Co., Ltd.) was changed to 25.0 parts by mass of another Mn-Zn type ferrite powder ("MZ03S_2" manufactured by Powdertech Co., Ltd., a Mn-Zn type ferrite powder with Fe: 43.1%, Mn: 22.2%, and Zn: 4.8%, average particle size (D₅₀) : 0.4 um, true density: 5.1 g/cm³).

A varnish-like resin composition 10 was prepared in the same manner as in Example 2 except the above matter.

### Comparative Example 2: Preparation of Varnish-Like Resin Composition 11

In Example 1, 19.6 parts by mass of the Mn-Zn type ferrite powder ("MZ03S_1" manufactured by Powdertech Co., Ltd.) was changed to 19.6 parts by mass of a Mn type ferrite powder ("M03S_2" manufactured by Powdertech Co., Ltd., a Mn type ferrite powder with Fe: 62.3% and Mn: 8.1%, average particle size (D₅₀) : 0.4 um, true density: 5.1 g/cm³) .

A varnish-like resin composition 11 was prepared in the same manner as in Example 1 except the above matter.

### Comparative Example 3: Preparation of Varnish-Like Resin Composition 12

In Example 1,
1) the amount of the Fe-Ni type alloy magnetic powder ("AKT-PB-2Cr" manufactured by Mitsubishi Steel Mfg. Co., Ltd.) was changed from 65.5 parts by mass to 41.8 parts by mass, and
2) the amount of the Mn-Zn type ferrite powder ("MZ03S_1" manufactured by Powdertech Co., Ltd.) was changed from 19.6 parts by mass to 34.3 parts by mass.

A varnish-like resin composition 12 was prepared in the same manner as in Example 1 except the above matter.

### Comparative Example 4: Preparation of Varnish-Like Resin Composition 13

In Example 2, 56.4 parts by mass of the Fe-Ni-Cr type alloy magnetic powder ("AKT-PB-2Cr" manufactured by Mitsubishi Steel Mfg. Co., Ltd.) was changed to 56.4 parts by mass of a Fe-Ni-Mo type alloy magnetic powder ("AKT-78Ni-5Mo" manufactured by Mitsubishi Steel Mfg. Co., Ltd., an alloy with Fe: 16.4%, Ni: 78.8%, Si: 0.2%, and Mo: 4.5%, average particle size (D₅₀) : 5 um, true density: 8.0 g/cm³).

A varnish-like resin composition 13 was prepared in the same manner as in Example 2 except the above matter.

### Production of Resin Sheet

A PET film ("Lumirror R80" manufactured by Toray Industries, Inc., thickness: 38 um, softening point: 130°C) subjected to release treatment with an alkyd resin type release agent ("AL-5" manufactured by Lintec Corporation) was prepared as a support. The varnish-type resin composition (resin varnish) produced in each of the examples and the comparative examples was applied onto the support with a die coater such that the thickness of the resin composition layer after drying was 70 um and dried at 90°C for 5 minutes to obtain a resin sheet.

### Production of Sheet-Like Cured Product

The resin sheet was cut into 200 mm square. The cut resin sheet (200 mm square) was laminated on one side of a polyimide film ("Upilex 25S" manufactured by Ube Industries, Ltd., 25 um thick, 240 mm square) such that the resin composition layer was in contact with the center of the smoothed face of the polyimide film using a batch type vacuum pressurization laminator (a two-stage build-up laminator "CVP700" manufactured by Nikko-Materials Co., Ltd.). The lamination was performed by reducing the pressure for 30 seconds to achieve an air pressure of 13 hPa or less, followed by compression bonding for 30 seconds at 100°C at a pressure of 0.74 MPa. This produced a multilayer film having a layer configuration of support/resin composition layer/polyimide film.

After peeling off the support, the resin composition layer was thermally cured by heating at 190°C for 90 minutes. The polyimide film was then peeled off to obtain a sheet-like cured product of the resin composition.

### Measurement of Specific Magnetic Permeability and Loss Factor

The obtained sheet-like cured product was cut to obtain a donut-like evaluation sample with an outer diameter of 19.2 mm and an inner diameter of 8.2 mm. The specific magnetic permeability (p') and the magnetic loss (µ") of this evaluation sample were measured using a magnetic material test fixture "16454A" manufactured by Keysight and an impedance analyzer "E4991B" manufactured by Keysight at a measurement frequency of 20 MHz at a room temperature of 23°C. The loss factor tanδ was calculated by the expression "tanδ = µ''/µ'."

The evaluation criteria for the specific magnetic permeability (p') are as follows:
"O": The specific magnetic permeability is 23 or more.
"X": The specific magnetic permeability is less than 23.

The evaluation criteria for the loss factor (tanδ) are as follows:
"O": The loss factor is 0.04 or less.
"X": The loss factor exceeds 0.04.

**Table 1**

| **[Table 1. Compositions and results of Examples** 1 **to 6]** | | | | | | | | | |
|---|---|---|---|---|---|---|---|---|---|
| | | | The ratio of nonvolative component (% by mass) | Example | | | | | |
| | | | | 1 | 2 | 3 | 4 | 5 | 6 |
| (A) | Ni-containing iron alloy type magnetic powder | AKT-PB-2Cr | 100 | 65.5 | 56.4 | 52.7 | 56.4 | 65.5 | 56.4 |
| | | AKT-PB-1Cr | 100 | | | | | | |
| | | AKT-PB-3Cr | 100 | | | | | | |
| | | AKT-PB-4Cr | 100 | | | | | | |
| | | AKT-78Ni-5Mo | 100 | | | | | | |
| (B) | Mn-containing ferrite type magnetic powder | MZ03S_1 | 100 | 19.6 | 25.0 | 27.9 | | | |
| | | MZ03S_2 | 100 | | | | | | |
| | | M03S_1 | 100 | | | | 25.0 | | |
| | | M03S_2 | 100 | | | | | | |
| | | M03S_3 | 100 | | | | | 19.6 | 25.0 |
| (C) | (C-1) Epoxy resin | ZX-1059 | 100 | 1.63 | 1.63 | 1.63 | 1.63 | 1.63 | 1.63 |
| | (C-2) Cureing agent | LA-7054 | 60 | 1.85 | 1.85 | 1.85 | 1.85 | 1.85 | 1.85 |
| (E) | Thermoplastic resin | YX7553BH30 | 30 | 1.61 | 1.61 | 1.61 | 1.61 | 1.61 | 1.61 |
| (F) | Curing accelerator | 2E4MZ | 100 | 0.01 | 0.01 | 0.01 | 0.01 | 0.01 | 0.01 |
| (G) | Dispersant | PB-881 | 100 | 0.70 | 0.70 | 0.70 | 0.70 | 0.70 | 0.70 |
| Total amount of the all components (parts by mass) | | | | 90.9 | 872 | 86.4 | 87.2 | 90.9 | 87.2 |
| Total amount of the all nonvolatile components (parts bv mass) | | | | 89.0 | 85.4 | 84.5 | 85.4 | 89.0 | 85.4 |
| Total amount of the component (A) and the component (B) (% by mass) | | | | 956 | 954 | 95.3 | 95.4 | 95.6 | 95.4 |
| Total amount of the component (A) and the component (B) (% by volume) | | | | 53.5 | 46.3 | 42.9 | 46.3 | 53.5 | 46.3 |
| The value of (Mn + Zn)/Fe in the component (A) and the component (B) (mass ratio) | | | | 0.102 | 0.137 | 0.155 | 0.155 | 0.060 | 0.080 |
| Results | | Specific magnetic permeability at 20 MHz frequency | Mesured value | 24.7 | 23.9 | 24.2 | 25.5 | 25.5 | 25.3 |
| | | | Evaluation | ○ | ○ | ○ | ○ | ○ | ○ |
| | | Loss factor (tan *δ*) at 20 MHz frequency | Mesured value | 0.029 | 0.029 | 0.029 | 0.032 | 0.029 | 0.027 |
| | | | Evaluation | ○ | ○ | ○ | ○ | ○ | ○ |

**Table 2**

| **[Table 2. Compositions and results of Examples 7 to 9 and Comparative Examples 1 to 4]** | | | | | | | | | | |
|---|---|---|---|---|---|---|---|---|---|---|
| | | | The ratio of nonvolative component (% by mass) | Example | | | Comparative Example | | | |
| | | | | 7 | 8 | 9 | 1 | 2 | 3 | 4 |
| (A) | Ni-containing iron alloy type magnetic powder | AKT-PB-2Cr | 100 | | | | 56.4 | 65.5 | 41.8 | |
| | | AKT-PB-1Cr | 100 | 6 5.5 | | | | | | |
| | | AKT-PB-3Cr | 100 | | 65.5 | | | | | |
| | | AKT-PB-4Cr | 100 | | | 65.5 | | | | |
| | | AKT-78Ni-5Mo | 100 | | | | | | | 56.4 |
| (B) | Mn-containing ferrite type magnetic powder | MZ03S_1 | 100 | 19.6 | 19.6 | 19.6 | | | 34.3 | 25.0 |
| | | MZ03S_2 | 100 | | | | 25.0 | | | |
| | | M03S_1 | 100 | | | | | | | |
| | | M03S_2 | 100 | | | | | 19.6 | | |
| | | M03S_3 | 100 | | | | | | | |
| (C) | (C-1) Epoxy resin | ZX-1059 | 100 | 1.63 | 1.63 | 1.63 | 1.63 | 1.63 | 1.63 | 1.63 |
| | (C-2) Cureing agent | LA-7054 | 60 | 1.85 | 1.85 | 1.85 | 1.85 | 1.85 | 1.85 | 1.85 |
| (E) | Thermoplastic resin | YX7553BH30 | 30 | 1.61 | 1.61 | 1.61 | 1.61 | 1.61 | 1.61 | 1.61 |
| (F) | Curing accelerator | 2E4MZ | 100 | 0.01 | 0.01 | 0.01 | 0.01 | 0.01 | 0.01 | 0.01 |
| (G) | Dispersant | PB-881 | 100 | 0.70 | 0.70 | 0.70 | 0.70 | 0.70 | 0.70 | 0.70 |
| Total amount of the all components (parts by mass) | | | | 90.9 | 90.9 | 90.9 | 87.2 | 90.9 | 81.9 | 87.2 |
| Total amount of the all nonvolatile components (parts bv mass) | | | | 89.0 | 89.0 | 89.0 | 85.4 | 89.0 | 80.1 | 85.4 |
| Total amount of the component (A) and the component (B) (% by mass) | | | | 956 | 956 | 956 | 95.4 | 95.6 | 95.1 | 95.4 |
| Total amount of the component (A) and the component (B) (% by volume) | | | | 53.5 | 53.5 | 53.5 | 46.3 | 53.5 | 34.3 | 463 |
| The value of (Mn + Zn)/Fe in the component (A) and the component (B) (mass ratio) | | | | 0.101 | 0.104 | 0.107 | 0.168 | 0.034 | 0.204 | 0.268 |
| Results | | Specific magnetic permeability at 20 MHz frequency | Mesured value | 24.9 | 24.9 | 23.6 | 22.7 | 22.3 | 22.6 | 25.8 |
| | | | Evaluation | ○ | ○ | ○ | × | × | × | ○ |
| | | Loss factor (tan *δ*) at 20 MHz frequency | Mesured value | 0.030 | 0.029 | 0.027 | 0.029 | 0.022 | 0.024 | 0.045 |
| | | | Evaluation | ○ | ○ | ○ | ○ | ○ | ○ | × |

In Table 1 and Table 2 above, "Total amount of component (A) and component (B) (% by mass)" represents a content relative to 100% by mass of the nonvolatile components in the resin composition, and "Total amount of component (A) and component (B) (% by volume)" represents a content relative to 100% by volume of the nonvolatile components in the resin composition. In Table 1 and Table 2 above, "Value of (Mn + Zn)/Fe in component (A) and component (B) (mass ratio)" represents the mass ratio of a total amount of Mn and Zn to an amount of Fe in an entire magnetic powder contained in the component (A) and the component (B).

### Reference Signs List

- 1: Circuit board

- 10: Core substrate
- 11: Supporting substrate
- 12: Metal layer
- 13: Metal layer
- 14: Through hole
- 20: Plated layer
- 21: Surrounding surface of polished surface
- 30: Cured product
- 30a: Resin composition
- 31: Polished surface of cured product (polished surface)
- 40: Conductor layer
- 41: Patterned conductor layer
- 100: Circuit board
- 200: Inner layer substrate
- 200a: First main surface
- 200b: Second main surface
- 220: Through hole
- 220a: Inside-the-through-hole wiring
- 240: External terminal
- 310: Resin Sheet
- 320: First cured product layer
- 320a: Resin composition layer
- 330: Support
- 360: Via hole
- 360a: Inside-the-via-hole wiring
- 400: Coil-shaped conductive structural body
- 420: First conductor layer
- 420a: Land
- 440: Second conductor layer

## Claims

1. A resin composition comprising:
(A) a Ni-containing iron alloy type magnetic powder;
(B) a Mn-containing ferrite type magnetic powder; and
(C) a thermosetting resin,
the component (A) containing a Fe-Ni-Cr type alloy magnetic powder,
the component (B) containing or not containing a Zn-containing ferrite type magnetic power, and
a mass ratio ((Mn + Zn)/Fe) of a total amount of Mn and Zn to an amount of Fe in an entire magnetic powder contained in the component (A) and the component (B) being 0.055 or more and 0.16 or less.

2. The resin composition according to claim 1, wherein the component (B) has a smaller average particle size (D₅₀) than the component (A).

3. The resin composition according to claim 1 or 2, wherein the component (C) contains (C-1) an epoxy resin.

4. The resin composition according to any one of claims 1 to 3, wherein the component (C) contains (C-2) a curing agent.

5. The resin composition according to any one of claims 1 to 4, further comprising (E) a thermoplastic resin.

6. The resin composition according to any one of claims 1 to 5, further comprising (F) a curing accelerator.

7. The resin composition according to any one of claims 1 to 6, further comprising (G) a dispersant.

8. The resin composition according to any one of claims 1 to 7, wherein a content of Ni contained in the component (A) is 33% by mass or more and 65% by mass or less relative to 100% by mass of the component (A).

9. The resin composition according to any one of claims 1 to 8, wherein a content of Mn contained in the component (B) is 5% by mass or more and 35% by mass or less relative to 100% by mass of the component (B).

10. The resin composition according to any one of claims 1 to 9, wherein an amount of the component (A) is 30% by volume or more relative to 100% by volume of nonvolatile components in the resin composition.

11. The resin composition according to any one of claims 1 to 10, wherein an amount of the component (A) is 40% by mass or more relative to 100% by mass of nonvolatile components in the resin composition.

12. The resin composition according to any one of claims 1 to 11, wherein an amount of the component (B) is 10% by volume or more relative to 100% by volume of nonvolatile components in the resin composition.

13. The resin composition according to any one of claims 1 to 12, wherein an amount of the component (B) is 10% by mass or more relative to 100% by mass of nonvolatile components in the resin composition.

14. The resin composition according to any one of claims 1 to 13, wherein a total amount of the component (A) and the component (B) is 60% by volume or more relative to 100% by volume of nonvolatile components in the resin composition.

15. The resin composition according to any one of claims 1 to 14, wherein a total amount of the component (A) and the component (B) is 70% by mass or more relative to 100% by mass of nonvolatile components in the resin composition.

16. The resin composition according to any one of claims 1 to 15, wherein the resin composition is for hole filling.

17. A cured product of the resin composition according to any one of claims 1 to 16.

18. A magnetic paste comprising the resin composition according to any one of claims 1 to 16.

19. A resin sheet comprising:
a support; and
a resin composition layer provided on the support,
the resin composition layer containing the resin composition according to any one of claims 1 to 16.

20. A circuit board comprising:
a substrate having holes; and
a cured product of the resin composition according to any one of claims 1 to 16 filled in the holes.

21. A circuit board comprising a cured product layer containing a cured product of the resin composition according to any one of claims 1 to 16.

22. An inductor substrate comprising the circuit board according to claim 21.
